# EUROPEAN PATENT APPLICATION

(11) **EP 4 773 182 A1**
(43) Date of publication of application: **08.07.2026**
(21) Application number: 24860001.7
(22) Date of filing: 30.08.2024
(51) Int. Cl.: H01L 23/12, H05K 1/11, H05K 3/40

(54) **THROUGH-ELECTRODE SUBSTRATE AND METHOD FOR MANUFACTURING THROUGH-ELECTRODE SUBSTRATE**

(30) Priority: 30.08.2023 JP 2023140353
(71) Applicant: Dai Nippon Printing Co., Ltd., Tokyo 162-8001 (JP)
(72) Inventor: TAWARAYA Seiji, Tokyo 162-8001 (JP); OOKAWA Yasuhiro, Tokyo 162-8001 (JP); MAWATARI Hiroshi, Tokyo 162-8001 (JP); SONE Yasuko, Tokyo 162-8001 (JP); KURAMOCHI Satoru, Tokyo 162-8001 (JP)
(74) Representative: Müller-Boré & Partner Patentanwälte PartG mbB
(86) International application number: PCT/JP2024/031400
(87) International publication number: WO 2025/047976

(57) **Abstract**

A through-via substrate may include a substrate including a first surface and a second surface located opposite the first surface, the substrate including a through hole including a wall surface extending from the first surface to the second surface; a through via including a first end face located at the first surface and a second end face located at the second surface, the through via filling the through hole; and an adhesive layer provided between the through via and the wall surface of the through hole. The through via may include a first layer including the first end face and a second layer including the second end face, the second layer being in contact with the first layer at an interface. The adhesive layer may extend along the wall surface toward the second surface in such a manner as not to reach the second surface. The adhesive layer may include a second end where the adhesive layer extending toward the second surface terminates. The interface may be located between the first surface and the second end of the adhesive layer or between the second surface and the second end of the adhesive layer in a thickness direction of the substrate.

## Description

### Technical Field

Embodiments of the present disclosure relate to a through-via substrate and a method of manufacturing a through-via substrate.

### Background Art

Through-via substrates have been employed in various uses. A through-via substrate includes a substrate including a through hole, and an electrode provided in the through hole. The through hole passes through the substrate from a first surface to a second surface. The through-via substrate is intended to electrically connect an electric element that is provided at the first surface and an electric element that is provided at the second surface to each other. The through-via substrate is also referred to as an interposer. Hereinafter, an electrode provided in a through hole is referred to as a through via.

Known examples of the through via include a filled via and a conformal via. The filled via includes an electrically conductive material, such as copper, that fills a through hole. The conformal via includes an electrically conductive layer extending along the wall surface of a through hole. From the viewpoint of reducing the electrical resistance, the filled via is preferable.

A filled via formed by plating tends to have a void. The term void refers to a hole defect that occurs in the filled via. A void occurs if the growing speed of plating in the through hole is not controlled appropriately. PTL 1 proposes suppressing the occurrence of any voids by providing a seed layer on a portion of the wall surface of the through hole, not over the entirety of the wall surface of the through hole.

### Citation List

### Patent Literature

PTL 1: International Publication No. 2023/085366

### Summary of Invention

### Technical Problem

At a location where the seed layer is absent, the through via is in contact with the wall surface of the through hole. The adhesion between the wall surface and the through via is lower than the adhesion between the seed layer and the wall surface. If the adhesion is insufficient, a gap occurs between the through via and the wall surface, which lowers the stability of the through via.

In view of the above circumstances, an object of embodiments of the present disclosure is to provide a through-via substrate including a through via exhibiting increased stability.

### Solution to Problem

Embodiments of the present disclosure relate to [1] to [23] below.
[1] A through-via substrate comprising:
   a substrate including a first surface and a second surface located opposite the first surface, the substrate including a through hole including a wall surface extending from the first surface to the second surface;
   a through via including a first end face located at the first surface and a second end face located at the second surface, the through via filling the through hole; and
   an adhesive layer provided between the through via and the wall surface of the through hole,
   wherein the through via includes a first layer including the first end face and a second layer including the second end face, the second layer being in contact with the first layer at an interface,
   wherein the adhesive layer extends along the wall surface toward the second surface in such a manner as not to reach the second surface,
   wherein the adhesive layer includes a second end where the adhesive layer extending toward the second surface terminates, and
   wherein the interface is located between the first surface and the second end of the adhesive layer or between the second surface and the second end of the adhesive layer in a thickness direction of the substrate.
[2] In the through-via substrate according to [1], the interface may be located between the second surface and the second end of the adhesive layer in the thickness direction.
[3] In the through-via substrate according to [2], a distance in the thickness direction between the first surface and the second end of the adhesive layer may be 2 µm or more and 250 µm or less.
[4] In the through-via substrate according to [2] or [3], a ratio of a distance in the thickness direction between the first surface and the interface with respect to a thickness of the substrate may be 0.002 or more and 0.500 or less.
[5] In the through-via substrate according to any one of [2] to [4], a ratio of a distance in the thickness direction between the first surface and the interface with respect to a thickness of the substrate may be 0.05 or more and 0.95 or less.
[6] In the through-via substrate according to any one of [2] to [5], a distance in the thickness direction between the first surface and the second end of the adhesive layer may be 5 µm or more, and a ratio of a distance in the thickness direction between the second surface and the interface with respect to a thickness of the substrate may be greater than a ratio of a distance in the thickness direction between the first surface and the interface with respect to the thickness of the substrate.
[7] In the through-via substrate according to [1], the interface may be located between the first surface and the second end of the adhesive layer in the thickness direction.
[8] In the through-via substrate according to [7], a distance in the thickness direction between the first surface and the interface may be 5 µm or more and 250 µm or less.
[9] In the through-via substrate according to [7] or [8], a ratio of a distance in the thickness direction between the first surface and the interface with respect to a thickness of the substrate may be 0.010 or more and 0.500 or less.
[10] In the through-via substrate according to any one of [7] to [9], a ratio of a distance in the thickness direction between the first surface and the second end of the adhesive layer with respect to a thickness of the substrate may be 0.05 or more and 0.95 or less.
[11] In the through-via substrate according to any one of [7] to [10], a distance in the thickness direction between the first surface and the interface may be 10 µm or more, and a ratio of a distance in the thickness direction between the second surface and the second end of the adhesive layer with respect to a thickness of the substrate may be greater than a ratio of a distance in the thickness direction between the first surface and the second end of the adhesive layer with respect to the thickness of the substrate.
[12] In the through-via substrate according to any one of [1] to [11], the adhesive layer may contain titanium, a titanium compound, chromium, or a chromium compound.
[13] In the through-via substrate according to any one of [1] to [12], the through via may contain copper.
[14] In the through-via substrate according to any one of [1] to [13], the substrate may contain glass and may have a thickness of 300 µm or more and 1200 µm or less.
[15] The through-via substrate according to any one of [1] to [14] may further comprise at least one of a first wiring layer located at the first surface and a second wiring layer located at the second surface. The first wiring layer may include a first conductive layer and a first insulating layer. The second wiring layer may include a second conductive layer and a second insulating layer.
[16] The through-via substrate according to [15] may further comprise a semiconductor device including a terminal electrically connected to the through via.
[17] In the through-via substrate according to [15], the through via may include a seed layer located on the adhesive layer, and a distance in the thickness direction between the interface and an end of the seed layer may be 50 nm or less.
[18] A method of manufacturing a through-via substrate, comprising:
   a step of preparing a substrate including a first surface and a second surface located opposite the first surface, the substrate including a through hole including a wall surface extending from the first surface to the second surface;
   a step of forming an adhesive layer on the wall surface; and
   a through-via-forming step of forming a through via in the through hole,
   wherein the adhesive layer extends along the wall surface toward the second surface in such a manner as not to reach the second surface,
   wherein the adhesive layer includes a second end where the adhesive layer extending toward the second surface terminates,
   wherein the through-via-forming step includes
   a step of forming a seed layer including at least a portion located on the adhesive layer;
   a first electroplating step of forming a first layer by electroplating such that the first layer covers the seed layer; and
   a second electroplating step of forming a second layer by electroplating such that the second layer is in contact with the first layer at an interface, and
   wherein the interface is located between the first surface and the second end of the adhesive layer or between the second surface and the second end of the adhesive layer in a thickness direction of the substrate.
[19] In the method of manufacturing a through-via substrate according to [18], the seed layer may be present only on the adhesive layer, and the interface may be located between the first surface and the second end of the adhesive layer in the thickness direction.
[20] In the method of manufacturing a through-via substrate according to [18], the seed layer may be present over the adhesive layer and the wall surface in such a manner as to cover the second end of the adhesive layer, and the interface may be located between the second surface and the second end of the adhesive layer in the thickness direction.
[21] In the method of manufacturing a through-via substrate according to any one of [18] to [20], the adhesive layer may be formed by chemical vapor deposition.
[22] In the method of manufacturing a through-via substrate according to any one of [18] to [21], the adhesive layer may be formed by atomic layer deposition.
[23] In the method of manufacturing a through-via substrate according to any one of [18] to [22], the seed layer may be formed by physical film forming.

### Advantageous Effects of Invention

According to any of the embodiments of the present disclosure, a through-via substrate including a through via can be provided while the occurrence of any voids is suppressed.

### Brief Description of Drawings

[Fig. 1] Fig. 1 is a sectional view illustrating a through-via substrate.
[Fig. 2A] Fig. 2A is a sectional view illustrating a through hole provided in the through-via substrate according to a first embodiment.
[Fig. 2B] Fig. 2B is a sectional view illustrating an exemplary second end of an adhesive layer.
[Fig. 3] Fig. 3 illustrates a first surface of the through-via substrate.
[Fig. 4] Fig. 4 illustrates a second surface of the through-via substrate.
[Fig. 5] Fig. 5 is a sectional view illustrating a step of manufacturing the through-via substrate according to the first embodiment.
[Fig. 6] Fig. 6 is a sectional view illustrating a step of manufacturing the through-via substrate according to the first embodiment.
[Fig. 7] Fig. 7 is a sectional view illustrating a step of manufacturing the through-via substrate according to the first embodiment.
[Fig. 8] Fig. 8 is a sectional view illustrating a step of manufacturing the through-via substrate according to the first embodiment.
[Fig. 9] Fig. 9 is a sectional view illustrating a step of manufacturing the through-via substrate according to the first embodiment.
[Fig. 10] Fig. 10 is a sectional view illustrating a step of manufacturing the through-via substrate according to the first embodiment.
[Fig. 11] Fig. 11 is a sectional view illustrating a step of manufacturing the through-via substrate according to the first embodiment.
[Fig. 12] Fig. 12 is a sectional view illustrating a step of manufacturing the through-via substrate according to the first embodiment.
[Fig. 13] Fig. 13 is a diagram for describing an exemplary advantageous effect produced in the through-via substrate according to the first embodiment.
[Fig. 14] Fig. 14 illustrates a through-via substrate according to a first comparative embodiment.
[Fig. 15] Fig. 15 illustrates a through-via substrate according to a second comparative embodiment.
[Fig. 16] Fig. 16 illustrates a through-via substrate according to a third comparative embodiment.
[Fig. 17] Fig. 17 is a sectional view illustrating a variation of the through hole.
[Fig. 18] Fig. 18 is a sectional view illustrating a variation of the through hole.
[Fig. 19] Fig. 19 is a sectional view illustrating a variation of the through hole.
[Fig. 20] Fig. 20 is a sectional view illustrating a variation of the through hole.
[Fig. 21] Fig. 21 is a sectional view illustrating a variation of the through-via substrate.
[Fig. 22] Fig. 22 is a sectional view illustrating a variation of the through-via substrate.
[Fig. 23] Fig. 23 is a sectional view illustrating a variation of the through-via substrate.
[Fig. 24] Fig. 24 is a sectional view illustrating a variation of the through-via substrate.
[Fig. 25] Fig. 25 is a sectional view illustrating an exemplary through-via substrate including a wiring layer.
[Fig. 26] Fig. 26 is a sectional view illustrating an exemplary through-via substrate including a wiring layer.
[Fig. 27] Fig. 27 is a sectional view illustrating an exemplary through-via substrate including a wiring layer.
[Fig. 28] Fig. 28 illustrates exemplary products that include through-via substrates.
[Fig. 29] Fig. 29 is a sectional view illustrating a through hole provided in a through-via substrate according to a second embodiment.
[Fig. 30] Fig. 30 is a sectional view illustrating a step of manufacturing the through-via substrate according to the second embodiment.
[Fig. 31] Fig. 31 is a sectional view illustrating a step of manufacturing the through-via substrate according to the second embodiment.
[Fig. 32] Fig. 32 is a sectional view illustrating a step of manufacturing the through-via substrate according to the second embodiment.
[Fig. 33] Fig. 33 is a diagram for describing an advantageous effect produced in the through-via substrate according to the second embodiment.
[Fig. 34] Fig. 34 is a table summarizing the results of evaluation of Working Examples A1 to A10 and Comparative Example A1.
[Fig. 35] Fig. 35 is a table summarizing the results of evaluation of Working Examples B1 to B10 and Comparative Example B1.
[Fig. 36] Fig. 36 illustrates observation positions for the through hole of Working Example B11.
[Fig. 37] Fig. 37 is an image obtained as a result of observation for the through hole of Working Example B11.
[Fig. 38] Fig. 38 is an image obtained as a result of observation for the through hole of Working Example B11.
[Fig. 39] Fig. 39 is an image obtained as a result of observation for the through hole of Working Example B11.
[Fig. 40] Fig. 40 is an image obtained as a result of observation for the through hole of Working Example B11.
[Fig. 41] Fig. 41 is an image obtained as a result of observation for the through via of Working Example B12.
[Fig. 42] Fig. 42 is an image obtained as a result of observation for the through via of Working Example B12.

### Description of Embodiments

Configurations of a through-via substrate and a substrate as an application thereof, and a method of manufacturing the same will now be described in detail as a first embodiment of the present disclosure with reference to the drawings. The following embodiments are only exemplary embodiments of the present disclosure, and the present disclosure is not to be construed as being limited thereto. Terms such as "parallel" and "orthogonal", values representing lengths and angles, and other like expressions that are used in this specification to define shapes and geometrical conditions and the degrees of such factors are not bound by the exact meanings thereof and are to be construed as encompassing those that can be expected to exert the same or similar functions.

In this specification, when a plurality of possible upper limits and a plurality of possible lower limits are given regarding a parameter, the numerical range of that parameter may be defined as a combination of any one of the possible upper limits and any one of the possible lower limits. For example, let us consider a description "The parameter B is A1 or more, for example, and may be A2 or more or A3 or more. The parameter B is A4 or less, for example, and may be A5 or less or A6 or less." In this case, the numerical range of the parameter B may be A1 or more and A4 or less, A1 or more and A5 or less, A1 or more and A6 or less, A2 or more and A4 or less, A2 or more and A5 or less, A2 or more and A6 or less, A3 or more and A4 or less, A3 or more and A5 or less, or A3 or more and A6 or less.

In the drawings to be referred to in the following embodiments, elements that are the same as each other or have the same or similar functions to each other are denoted by the same or similar reference signs, and redundant description of such elements may be omitted. As a matter of convenience of description, the drawings may not be to scale, and some elements may be omitted from the drawings.

### (Through-Via Substrate)

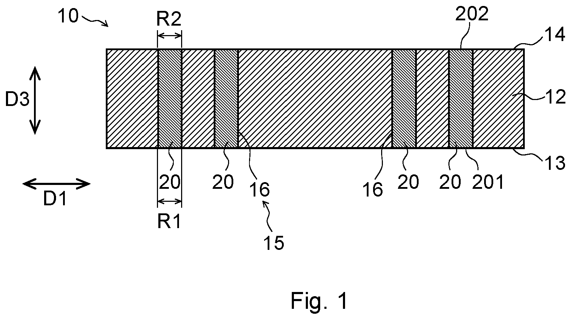

Fig. 1 is a sectional view illustrating an exemplary through-via substrate 10. The through-via substrate 10 includes a substrate 12 and a plurality of through vias 20.

### (Substrate)

The substrate 12 includes a first surface 13 and a second surface 14. The second surface 14 is located opposite the first surface 13.

The substrate 12 includes a plurality of through holes 15, which pass through the substrate 12 from the first surface 13 to the second surface 14. The through holes 15 each include a wall surface 16, which extends from the first surface 13 to the second surface 14. Hereinafter, a direction heading from the first surface 13 toward the second surface 14 is also referred to as a thickness direction D3. The thickness direction D3 may be parallel to a direction normal to the first surface 13. Directions in which the first surface 13 spreads are also referred to as planar directions. A first direction D1, illustrated in Fig. 1, is one of the planar directions. The first direction D1 is defined as a direction in which the number of through vias 20 that are located side by side is largest.

The substrate 12 is made of an inorganic material having an insulation characteristic. For example, the substrate 12 contains, as a chief component, glass, quartz, sapphire, resin, silicon, silicon carbide, alumina (Al₂O₃), aluminum nitride (AIN), zirconium oxide (ZrO₂), or the like. The term chief component refers to a component with a content of 51% by mass or more.

If the substrate 12 contains silicon, surfaces of the substrate 12 including the first surface 13, the second surface 14, and the wall surface 16 may be in the form of an insulating film. The insulating film is obtained by, for example, oxidizing the substrate 12 including the through holes 15 with high temperature.

The substrate 12 may have a rectangular shape in plan view. A rectangular substrate 12 is also referred to as a panel. The substrate 12 may have a circular shape in plan view. A circular substrate 12 is also referred to as a wafer. The phrase in plan view refers to viewing an object in the thickness direction D3 of the first surface 13.

The substrate 12 has a thickness T0 of 100 µm or more, for example. The thickness T0 may be 200 µm or more or 300 µm or more. Setting the thickness T0 to 100 µm or more can suppress the increase in the flexure of the substrate 12, which can reduce the difficulty in the handling of the substrate 12 during the manufacturing process and/or can suppress the warpage of the substrate 12 attributed to an internal stress occurring in a layer formed on the substrate 12. The thickness T0 of the substrate 12 is 1200 µm or less, for example, and may be 1000 µm or less or 500 µm or less. Setting the thickness T0 to 1200 µm or less can suppress the increase in the duration of a process of making through holes 15 in the substrate 12.

### (Through Via)

The through vias 20 are members that are located in the through holes 15 and are electrically conductive. The through vias 20 fill the respective through holes 15. The through vias 20 are each a so-called filled via.

As illustrated in Fig. 1, each through via 20 includes a first end face 201 and a second end face 202. The first end face 201 is located at the first surface 13. The second end face 202 is located at the second surface 14. The first end face 201 may be flush with the first surface 13. The second end face 202 may be flush with the second surface 14.

The through hole 15 has a dimension R1 at the first surface 13. The through hole 15 has a dimension R2 at the second surface 14. The dimension R1 and the dimension R2 may be equal to each other. The dimension R1 and the dimension R2 may be different from each other. For example, the dimension R1 may be greater than the dimension R2 or may be smaller than the dimension R2.

The dimension R1 is 5 µm or more, for example, and may be 10 µm or more or 20 µm or more. The dimension R1 is 100 µm or less, for example, and may be 80 µm or less or 60 µm or less. The numerical range of the dimension R2 may be the same as the numerical range of the dimension R1.

The through hole 15 may have a large aspect ratio. The aspect ratio refers to the ratio of the thickness T0 of the substrate 12 to the minimum dimension of the through hole 15 in the planar direction. If the dimension of the through hole 15 is uniform in the thickness direction D3, the aspect ratio is calculated as T0/R1. The aspect ratio is 3.0 or more, for example, and may be 4.0 or more or 5.0 or more. The aspect ratio is 25.0 or less, for example, and may be 20.0 or less or 15.0 or less. For example, the aspect ratio may be 3.0 or more and 25.0 or less. Setting the aspect ratio to 3.0 or more can suppress the occurrence of a situation where the through hole 15 is not filled with the through via 20 at the first surface 13. Setting the aspect ratio to 25.0 or less can reduce the duration of a process of forming the through via 20 by plating.

The plan-view shape of the through hole 15 is not particularly limited. For example, the plan-view shape of the through hole 15 may be a circle but is not limited to being a circle. If the plan-view shape of the through hole 15 is a circle, the dimension R1 and the dimension R2 described above refer to the diameter of the through hole 15 at the first surface 13 and the diameter of the through hole 15 at the second surface 14, respectively. If the plan-view shape of the through hole 15 is not a circle, the dimension R1 and the dimension R2 described above are defined in a direction in which the dimension of the through hole 15 in plan view is largest. For example, if the plan-view shape of the through hole 15 is an oval, the dimension R1 and the dimension R2 described above are defined in the direction of the major axis of the oval.

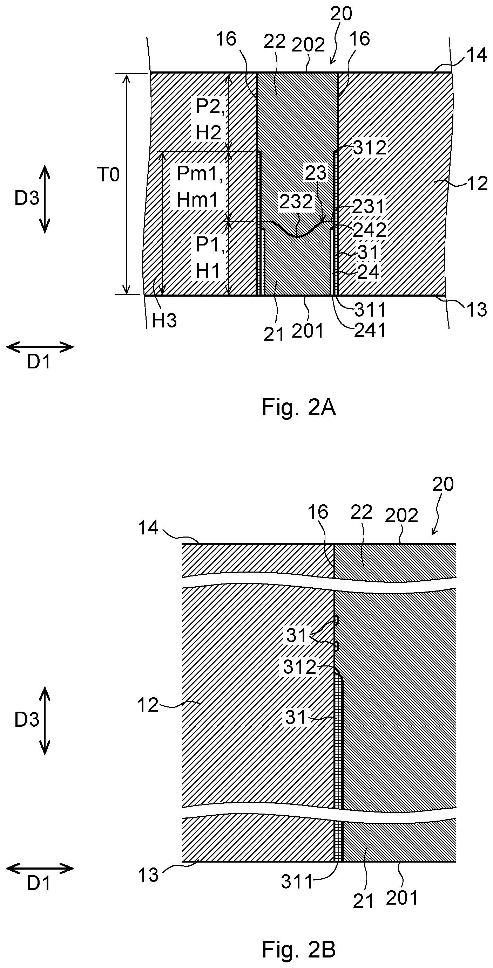

An internal configuration of the through hole 15 will now be described in detail. Fig. 2A is a sectional view illustrating an exemplary through hole 15. The through-via substrate 10 includes an adhesive layer 31, which is provided between the through via 20 and the wall surface 16. The adhesive layer 31 may be in contact with the wall surface 16.

As illustrated in Fig. 2A, the through via 20 includes a first layer 21, a second layer 22, and a seed layer 24. The first layer 21 includes the first end face 201. The second layer 22 includes the second end face 202. The first layer 21 and the second layer 22 are stacked in the thickness direction D3. The seed layer 24 is located between the first layer 21 and the through hole 15. In the example illustrated in Fig. 2A, the seed layer 24 is located between the first layer 21 and the adhesive layer 31. The seed layer 24 may be in contact with the adhesive layer 31. The seed layer 24 may be in contact with the first layer 21.

As to be described below, the first layer 21 is formed in a first electroplating step. The second layer 22 is formed in a second electroplating step, which is performed after the first electroplating step. The second layer 22 is in contact with the first layer 21 in the thickness direction D3 at an interface 23. The interface 23 laterally extends across the through hole 15. The interface 23 may be formed as a grain boundary of the material constituting the first layer 21.

The adhesive layer 31 will now be described in detail. The adhesive layer 31 is a layer for increasing the adhesion of the through via 20 to the wall surface 16. For example, the adhesive layer 31 can suppress the occurrence of a gap between the through via 20 and the wall surface 16.

However, if the adhesion of the through via 20 to the wall surface 16 is excessively high, the substrate 12 may have damage, such as cracks, attributed to the difference between the coefficient of thermal expansion of the through via 20 and the coefficient of thermal expansion of the substrate 12. In view of such circumstances, the present embodiment proposes a configuration in which the adhesive layer 31 is provided on a portion of the wall surface 16, not over the entirety of the wall surface 16.

In the example illustrated in Fig. 2A, the adhesive layer 31 extends in the thickness direction D3 along the wall surface 16 toward the second surface 14 in such a manner as not to reach the second surface 14. For example, the adhesive layer 31 has a cylindrical shape. The adhesive layer 31 includes a first end 311 and a second end 312. The first end 311 may be located at the first surface 13. The first end 311 may be spaced apart from the first surface 13 in the thickness direction D3. The second end 312 is located opposite the first end 311 in the thickness direction D3. The adhesive layer 31 extending from the first end 311 toward the second surface 14 terminates at the second end 312. The second end 312 is covered with neither the seed layer 24 nor the first layer 21.

Fig. 2B is a sectional view illustrating an exemplary second end 312 of the adhesive layer 31. The second end 312 of the adhesive layer 31 is the terminal end of the adhesive layer 31 that extends continuously from the first surface 13 toward the second surface 14. A portion of the adhesive layer 31 that extends continuously from the first surface 13 toward the second surface 14 and terminates at the second end 312 is also referred to as a main portion. As illustrated in Fig. 2B, the adhesive layer 31 may include a portion that is spaced apart from the main portion. The portion spaced apart from the main portion is also referred to as a separate portion. The second end 312 of the adhesive layer 31 is an end part of the main portion.

The adhesive layer 31 contains a material that is adhesive to the wall surface 16. The adhesive layer 31 contains a material that is adhesive to the wall surface 16. The material may be, for example, titanium (Ti), molybdenum (Mo), tungsten (W), tantalum (Ta), nickel (Ni), chromium (Cr), aluminum (Al), a compound of any of the foregoing, or an alloy of any of the foregoing. The compound may be a metal oxide such as titanium oxide (TiO₂), indium tin oxide (ITO), indium zinc oxide (IZO), zinc oxide (ZnO), tin oxide (SnO₂), or chromium oxide. The adhesive layer 31 may contain an organic substance such as a silane coupling agent. If the through via 20 contains copper (Cu), the adhesive layer 31 may contain a material that suppresses diffusion of Cu. For example, the adhesive layer 31 may contain a metal nitride such as titanium nitride (TiN), molybdenum nitride (MoN), tantalum nitride (TaN), or chromium nitride.

The material for the adhesive layer 31 may be selected in accordance with the material or shape of the substrate 12. For example, if the substrate 12 is a wafer, the adhesive layer 31 may contain Cr or a compound thereof. For example, if the substrate 12 is a panel, the adhesive layer 31 may contain Ti or a compound thereof.

The seed layer 24 will now be described in detail. The seed layer 24 is a layer that functions as a cathode in the first electroplating step. The first electroplating step starts with the precipitation of a material for constituting the first layer 21 on the seed layer 24. The seed layer 24 is adhesive to the first layer 21. For example, the adhesion between the seed layer 24 and the through via 20 is higher than the adhesion between the wall surface 16 and the through via 20.

The seed layer 24 extends in the thickness direction D3 along the wall surface 16 toward the second surface 14 in such a manner as not to reach the second surface 14. For example, the seed layer 24 has a cylindrical shape. The seed layer 24 includes a third end 241 and a fourth end 242. The third end 241 may be located at the first surface 13. The third end 241 may be spaced apart from the first surface 13 in the thickness direction D3. The fourth end 242 is located opposite the third end 241 in the thickness direction D3. The seed layer 24 extending from the third end 241 toward the second surface 14 terminates at the fourth end 242.

In the example illustrated in Fig. 2A, the fourth end 242 of the seed layer 24 is located closer to the first surface 13 than the second end 312 of the adhesive layer 31. In other words, the fourth end 242 is located between the first surface 13 and the second end 312 in the thickness direction D3. In such a configuration, the seed layer 24 is present only on the adhesive layer 31.

The material for the seed layer 24 is selected such that the first layer 21 can be precipitated on the seed layer 24. The material for the seed layer 24 may be the same as or different from the material for the first layer 21. The seed layer 24 may contain, for example, a metal material such as Cu, Ti, Cr, Ni, or gold (Au). The seed layer 24 may contain a compound of any of the above metal materials. For example, the seed layer 24 may contain TiN. The seed layer 24 may include a plurality of layers. For example, the seed layer 24 may include a TiN layer and a Cu layer.

The first layer 21 is formed by precipitation reaction utilizing electric charges supplied from the seed layer 24. In the through hole 15, the first layer 21 covers the seed layer 24. For example, the first layer 21 extends in the thickness direction D3 from the first surface 13 and reaches a position beyond the seed layer 24 toward the second surface 14.

The second layer 22 is in contact with the first layer 21 at the interface 23. The second layer 22 extends in the thickness direction D3 from the interface 23 and reaches the second surface 14.

The first layer 21 and the second layer 22 may each contain a metal material such as Cu, Au, silver (Ag), platinum (Pt), rhodium (Rh), Ni, Cr, or palladium (Pd). The first layer 21 and the second layer 22 may each contain a compound of any of the foregoing metal materials.

The interface 23 is not limited to being flat. For example, the interface 23 may include a dent 232, which is depressed toward the first surface 13. The dent 232 has a depth K of 1.5 µm or more, for example. The depth K may be 3.0 µm or more or 5.0 µm or more. The depth K of the dent 232 is less than 15 µm, for example, and may be less than 12 µm or less than 10 µm. For example, the depth K of the dent 232 may be 1.5 µm or more and less than 15 µm.

In some cases, the growth of the second layer 22 may progress faster at the plan-view center of the through hole 15 than near the wall surface 16 of the through hole 15. The interface 23 including the dent 232 can suppress excessive projection of the second layer 22 from the second surface 14 at the plan-view center of the through hole 15. Setting the depth K of the dent 232 to less than 15 µm can suppress the occurrence of any defects, such as voids, during the growth of the second layer 22.

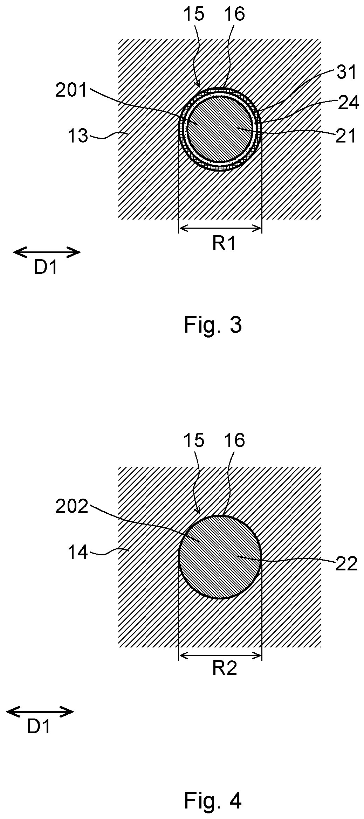

Fig. 3 illustrates the first surface 13 of the through-via substrate 10. At the first surface 13, the adhesive layer 31 and the seed layer 24 are present between the wall surface 16 of the through hole 15 and the first layer 21. If the material for the seed layer 24 and the material for the first layer 21 are the same, the boundary between the seed layer 24 and the first layer 21 may be unclear. The through hole 15 has the dimension R1 at the first surface 13. The dimension R1 is the maximum value for the dimension of the through hole 15 at the first surface 13.

Fig. 4 illustrates the second surface 14 of the through-via substrate 10. At the second surface 14, the adhesive layer 31 and the seed layer 24 are absent between the wall surface 16 of the through hole 15 and the second layer 22. The through hole 15 has the dimension R2 at the second surface 14. The dimension R2 is the maximum value for the dimension of the through hole 15 at the second surface 14.

The position of the interface 23 in the thickness direction D3 will now be described. The interface 23 includes an interfacial end 231. The interfacial end 231 is the plan-view outer edge of the interface 23. The interfacial end 231 is located close to the fourth end 242 of the seed layer 24 in the thickness direction D3. The position of the fourth end 242 of the seed layer 24 can be estimated from the position of the interfacial end 231.

In the example illustrated in Fig. 2A, the interface 23 is located between the first surface 13 and the second end 312 of the adhesive layer 31 in the thickness direction D3. The through via 20 is sectioned into a middle portion, a first portion P1, and a second portion P2 in the thickness direction D3 with reference to the interfacial end 231 of the interface 23 and the second end 312 of the adhesive layer 31. The middle portion is a portion of the through via 20 that is located between the interfacial end 231 of the interface 23 and the second end 312 of the adhesive layer 31 in the thickness direction D3. As illustrated in Fig. 2A, if the interfacial end 231 of the interface 23 is located between the first surface 13 and the second end 312 of the adhesive layer 31, the middle portion is particularly referred to as a first middle portion and is denoted by reference sign Pm1. The first portion P1 is a portion of the through via 20 that is located between the first surface 13 and the first middle portion Pm1 in the thickness direction D3. In the example illustrated in Fig. 2A, the first portion P1 is located between the first surface 13 and the interfacial end 231 of the interface 23. The second portion P2 is a portion of the through via 20 that is located between the second surface 14 and the first middle portion Pm1 in the thickness direction D3. In the example illustrated in Fig. 2A, the second portion P2 is located between the second surface 14 and the second end 312 of the adhesive layer 31.

In most part of the first portion P1, the adhesive layer 31 and the seed layer 24 are present between the through via 20 and the wall surface 16. In the first middle portion Pm1, the adhesive layer 31 is present between the through via 20 and the wall surface 16. In the second portion P2, neither the adhesive layer 31 nor the seed layer 24 is present between the through via 20 and the wall surface 16.

The adhesion of the adhesive layer 31 to the wall surface 16 is higher than the adhesion of the through via 20 to the wall surface 16. Accordingly, the force of adhesion between the wall surface 16 and the through via 20 in the first middle portion Pm1 is greater than the force of adhesion between the wall surface 16 and the through via 20 in the second portion P2.

The adhesion of the through via 20 to the seed layer 24 and the adhesion of the seed layer 24 to the adhesive layer 31 are higher than the adhesion of the through via 20 to the adhesive layer 31. Accordingly, the force of adhesion between the wall surface 16 and the through via 20 in the first portion P1 is greater than the force of adhesion between the wall surface 16 and the through via 20 in the first middle portion Pm1.

The first portion P1 has a great force of adhesion. The first portion P1 can increase the stability of the through via 20.

The force of adhesion of the second portion P2 is smaller than the force of adhesion of the first portion P1 and the force of adhesion of the first middle portion Pm1. Accordingly, the thermal stress attributed to the difference between the coefficient of thermal expansion of the through via 20 and the coefficient of thermal expansion of the substrate 12 tends to be smaller in the second portion P2 than in the first portion P1 and in the first middle portion Pm1. Therefore, for example, the second portion P2 can absorb to some extent the thermal stress occurring in the first portion P1. For example, the thermal stress occurring in the first portion P1 can be dispersed by the second portion P2 inside the second portion P2 and in the thickness direction D3 or in the planar direction.

The force of adhesion of the first middle portion Pm1 is greater than the force of adhesion of the first portion P1 and is smaller than the force of adhesion of the second portion P2. The first middle portion Pm1 is located between the first portion P1 and the second portion P2 in the thickness direction D3. The first middle portion Pm1 can moderate the change in the thermal stress between the first portion P1 and the second portion P2. Such a characteristic suppresses the occurrence of damage, such as cracks, to the substrate 12 or the through via 20.

The first middle portion Pm1 has a thickness Hm1. The thickness Hm1 is the distance in the thickness direction D3 between the interfacial end 231 of the interface 23 and the second end 312 of the adhesive layer 31. The first portion P1 has a thickness H1. In the example illustrated in Fig. 2A, the thickness H1 is the distance in the thickness direction D3 between the first surface 13 and the interfacial end 231 of the interface 23. The second portion P2 has a thickness H2. In the example illustrated in Fig. 2A, the thickness H2 is the distance in the thickness direction D3 between the second surface 14 and the second end 312 of the adhesive layer 31.

The thickness H1 of the first portion P1 is 5 µm or more, for example, and may be 10 µm or more, 30 µm or more, 50 µm or more, or 100 µm or more. Setting the thickness H1 to a predetermined value or more can appropriately increase the adhesion between the through via 20 and the wall surface 16. The thickness H1 is 250 µm or less, for example, and may be 200 µm or less, 150 µm or less, 130 µm or less, 100 µm or less, 50 µm or less, or 40 µm or less. Setting the thickness H1 to 250 µm or less can suppress excessive increase in the adhesion of the through via 20 to the wall surface 16.

The thickness H1 of the first portion P1 may be determined relative to the thickness T0 of the substrate 12. H1/T0, representing the ratio of the thickness H1 to the thickness TO, is 0.005 or more, for example, and may be 0.010 or more, 0.025 or more, 0.050 or more, 0.075 or more, 0.10 or more, 0.15 or more, or 0.20 or more. H1/T0 is 0.50 or less, for example, and may be 0.40 or less, 0.30 or less, 0.25 or less, 0.20 or less, 0.15 or less, 0.10 or less, or 0.075 or less.

The thickness H2 of the second portion P2 is 50 µm or more, for example, and may be 100 µm or more, 200 µm or more, or 300 µm or more. Setting the thickness H2 to 50 µm or more can appropriately disperse the thermal stress that occurs in the through via 20. The thickness H2 is 950 µm or less, for example, and may be 500 µm or less, 350 µm or less, 250 µm or less, or 200 µm or less.

The thickness H2 of the second portion P2 may be determined relative to the thickness T0 of the substrate 12. H2/T0, representing the ratio of the thickness H2 to the thickness TO, is 0.10 or more, for example, and may be 0.15 or more, 0.20 or more, 0.40 or more, 0.60 or more, or 0.80 or more. H2/T0 is 0.95 or less, for example, and may be 0.90 or less, 0.85 or less, 0.70 or less, 0.60 or less, 0.50 or less, 0.40 or less, or 0.30 or less.

The thickness Hm1 of the first middle portion Pm1 is 30 µm or more, for example, and may be 40 µm or more, 50 µm or more, or 100 µm or more. Setting the thickness Hm1 to a predetermined value or more can moderate the change in the thermal stress between the first portion P1 and the second portion P2. The thickness Hm1 is 250 µm or less, for example, and may be 200 µm or less, 150 µm or less, 100 µm or less, 50 µm or less., or 40 µm or less.

The thickness Hm1 of the first middle portion Pm1 may be determined relative to the thickness T0 of the substrate 12. Hm1/TO, representing the ratio of the thickness Hm1 to the thickness TO, is 0.030 or more, for example, and may be 0.040 or more, 0.050 or more, 0.075 or more, 0.10 or more, 0.15 or more, or 0.20 or more. Hm1/T0 is 0.50 or less, for example, and may be 0.40 or less, 0.30 or less, 0.25 or less, 0.20 or less, 0.15 or less, 0.10 or less, or 0.075 or less.

The thickness H1 of the first portion P1, the thickness H2 of the second portion P2, and the thickness Hm1 of the first middle portion Pm1 may be set such that the three layers are well balanced. For example, the difference between the maximum value and the minimum value for each of H1/T0, H2/T0, and Hm1/TO may be 0.40 or less, 0.30 or less, or 0.20 or less.

In Fig. 2A, reference sign H3 denotes the distance in the thickness direction D3 between the first surface 13 and an end of the first middle portion Pm1 that is closer to the second surface 14. In the example illustrated in Fig. 2A, the distance H3 is the distance in the thickness direction D3 between the first surface 13 and the second end 312 of the adhesive layer 31. H3/TO, representing the ratio of the distance H3 to the thickness T0 of the substrate 12, is 0.05 or more, for example, and may be 0.10 or more, 0.15 or more, 0.30 or more, 0.50 or more, 0.70 or more, 0.75 or more, or 0.80 or more. H3/TO is 0.95 or less, for example, and may be 0.92 or less, 0.90 or less, 0.80 or less, 0.60 or less, 0.40 or less, or 0.20 or less.

The ratio H2/TO of the thickness H2 to the thickness T0 may be greater than the ratio H3/T0 of the distance H3 to the thickness T0. In other words, the second portion P2 may occupy a space greater than half the size of the through hole 15 in the thickness direction D3. As described above, the thermal stress attributed to the difference between the coefficient of thermal expansion of the through via 20 and the coefficient of thermal expansion of the substrate 12 tends to be smaller in the second portion P2 than in the first portion P1 and in the first middle portion Pm1. Setting the thickness H1 of the first portion P1 to a predetermined value or more while increasing the proportion of the second portion P2 in the through hole 15 enables the second portion P2 to more assuredly absorb the thermal stress that occurs in the first portion P1.

The value subtracting H3 from H2 is expressed as ΔH23. ΔH23/T0, representing the ratio of the difference ΔH23 to the thickness T0, is 0.10 or more, for example, and may be 0.20 or more, 0.25 or more, or 0.30 or more. ΔH23/T0 is 0.90 or less, for example, and may be 0.80 or less, 0.75 or less, or 0.70 or less.

The dimensions including the thicknesses of the layers located in the through hole 15 are calculated on the basis of sectional images of a plurality of through holes 15 that are taken through an electron microscope. Through holes 15 to be taken as measurement objects are five through holes 15 that are side by side in the first direction D1 at a position closest to the center point of the through-via substrate 10 in plan view. The sectional images are each taken such that the dimension of the through holes 15 in the first direction D1 becomes largest. Measurement results for the five through holes 15 are averaged to calculate the dimensions of the individual layers.

### (Method of Manufacturing Through-Via Substrate)

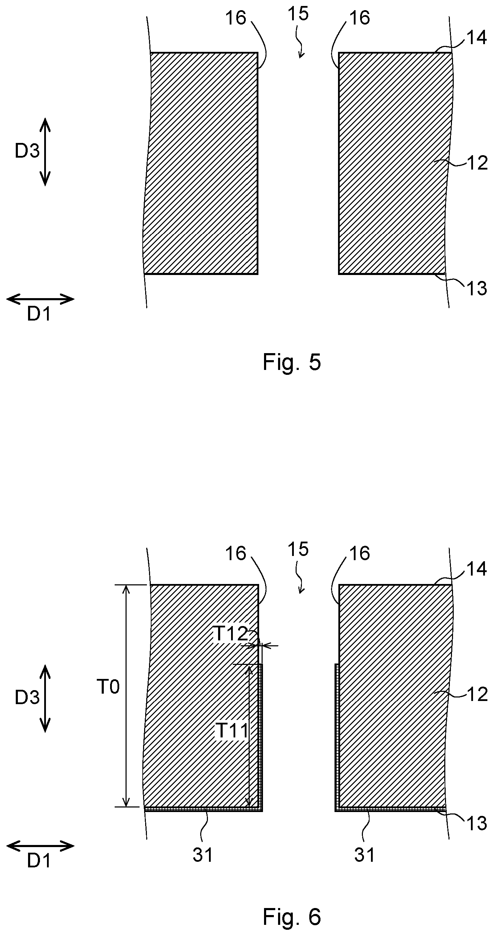

An exemplary method of manufacturing the through-via substrate 10 will now be described with reference to Figs. 5 to 12.

### (Through-Hole-Making Step)

First, a substrate 12 is prepared. Subsequently, a resist layer is provided on at least one of the first surface 13 and the second surface 14. Subsequently, an opening is made in the resist layer at a position corresponding to a through hole 15. Subsequently, the substrate 12 is processed at the opening of the resist layer. Thus, as illustrated in Fig. 5, a through hole 15 is made in the substrate 12. The technique of processing the substrate 12 may be dry etching, wet etching, or the like. Dry etching includes reactive ion etching, deep reactive ion etching, and the like.

To make a through hole 15 in the substrate 12, a laser beam may be applied to the substrate 12. In that case, the resist layer may be omitted. The laser may be an excimer laser, an Nd:YAG laser, a femtosecond laser, or the like. Employing an Nd:YAG laser enables the use of a fundamental wave having a wavelength of 1064 nm, a second harmonic having a wavelength of 532 nm, a third harmonic having a wavelength of 355 nm, and so forth.

Alternatively, laser application and wet etching may be combined as appropriate. Specifically, laser application is first performed on the substrate 12 to form an altered layer in a region of the substrate 12 where a through hole 15 is to be made. Subsequently, the substrate 12 is immersed in hydrogen fluoride or the like to etch the altered layer. Consequently, a through hole 15 is made in the substrate 12.

Alternatively, blasting of an abrasive to the substrate 12 may be employed to make a through hole 15 in the substrate 12.

### (Adhesive-Layer-Forming Step)

Subsequently, as illustrated in Fig. 6, an adhesive-layer-forming step of forming an adhesive layer 31 is performed. An adhesive layer 31 is formed on at least the wall surface 16 of the through hole 15. The adhesive layer 31 may be present on the first surface 13. The adhesive layer 31 may be present on the second surface 14, although not illustrated.

As illustrated in Fig. 6, the adhesive layer 31 on the wall surface 16 does not reach the second surface 14 in the thickness direction D3. For example, a resist layer is formed on a portion of the wall surface 16 that is to be located between the second end 312 of the adhesive layer 31 and the second surface 14. After the adhesive-layer-forming step, the resist layer is removed. Such a method suppresses the formation of an adhesive layer 31 on the portion of the wall surface 16 that is to be located between the second end 312 of the adhesive layer 31 and the second surface 14. Alternatively, after an adhesive layer 31 is formed over the entirety of the wall surface 16, a resist layer is formed on a portion of the adhesive layer 31 that has a desired dimension T11. Subsequently, an etching solution is supplied into the through hole 15 from the side of the second surface 14. Accordingly, the portion of the adhesive layer 31 that is not covered with the resist layer is removed.

In the thickness direction D3, the dimension T11 of a portion of the adhesive layer 31 that is present in the through hole 15 is smaller than the thickness T0 of the substrate 12. The numerical range of T11/T0, representing the ratio of the dimension T11 to the thickness T0 of the substrate 12, may be the same as the numerical range of H3/T0 described above.

The adhesive layer 31 has a thickness T12 of 5 nm or more, for example. The thickness T12 may be 10 nm or more or 20 nm or more. The thickness T12 is 300 nm or less, for example, and may be 100 nm or less or 50 nm or less. The thickness T12 of the adhesive layer 31 is defined at the center of the adhesive layer 31 in the thickness direction D3.

The adhesive layer 31 may be formed by physical film forming or chemical vapor deposition. Physical film forming includes, for example, vapor deposition, sputtering, and ion plating. Chemical vapor deposition includes, for example, atomic layer deposition. The adhesive layer 31 may be formed by any other technique of chemical vapor deposition, instead of atomic layer deposition.

An exemplary adhesive-layer-forming step in a case where an adhesive layer 31 is formed by atomic layer deposition will now be described. The adhesive-layer-forming step includes a plurality of film-forming processes. A first film-forming process includes a first supply process, a first purge process, a second supply process, and a second purge process.

In the first supply process, a source gas containing a first reactant is supplied to the substrate 12. The first reactant is also referred to as a precursor. The first reactant is, for example, a compound containing a metal included in the metal oxide constituting the adhesive layer 31. The first reactant may be a compound containing a metal included in the metal oxide constituting the adhesive layer 31, and an organic substance.

The first reactant reacts to the surface of the substrate 12 in a self-regulating manner. For example, the first reactant reacts only in a plurality of reactive regions at the surface of the substrate 12. The reaction of the first reactant forms a film of the first reactant at the surface of the substrate 12. When all of the reactive regions at the surface of the substrate 12 are filled with the first reactant, the growth of the film stops.

Subsequently, the first purge process is performed. In the first purge process, the first reactant remaining in the surrounding environment of the substrate 12 is removed. For example, the source gas containing the first reactant is discharged to the outside of a chamber of a film-forming apparatus configured to perform the film-forming process.

Subsequently, the second supply process is performed. In the second supply process, a source gas containing a second reactant is supplied to the substrate 12. The second reactant is oxygen molecules, hydrogen molecules, or the like. The second reactant may contain reactive oxygen radicals.

In the second supply process, surface ligands of the first reactant constituting the film are replaced by oxygen. That is, oxidation reaction occurs. Consequently, a film of metal oxide is formed at the surface of the substrate 12. When all of the surface ligands are replaced by oxygen, the oxidation reaction stops.

Subsequently, the second purge process is performed. In the second purge process, the second reactant remaining in the surrounding environment of the substrate 12 is removed. For example, the source gas containing the second reactant is discharged to the outside of the chamber of the film-forming apparatus configured to perform the film-forming process.

The thickness of the film of metal oxide to be formed in the first film-forming process is 0.20 nm or less, for example, and may be 0.15 nm or less or 0.10 nm or less. The thickness of the adhesive layer 31 can be controlled by controlling the number of times the film-forming process is to be performed.

As described above, in atomic layer deposition, the reaction occurs in a self-regulating manner. Therefore, a uniform and dense adhesive layer 31 with reduced detects such as pinholes can be obtained. Furthermore, since the reaction occurs between the adhesive layer 31 and a plurality of reactive regions at the surface of the substrate 12, the adhesion of the adhesive layer 31 to the substrate 12 is increased.

Atomic layer deposition provides another benefit that the adhesive layer 31 can be formed at a lower temperature than in other kinds of chemical vapor deposition such as plasma CVD. Atomic layer deposition provides yet another benefit that the adhesive layer 31 can be formed on the wall surface 16 of a through hole 15 having a greater aspect ratio than in other kinds of chemical vapor deposition such as plasma CVD. For example, atomic layer deposition enables the formation of an adhesive layer 31 on the wall surface 16 of a through hole 15 having an aspect ratio of 100 or more.

### (Seed-Layer-Forming Step)

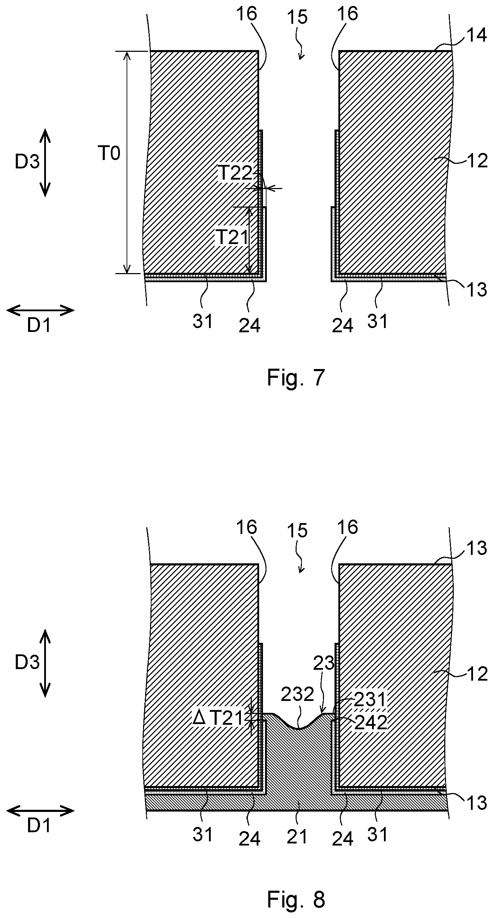

Subsequently, the through-via-forming step of forming a through via 20 in the through hole 15 is performed. First, as illustrated in Fig. 7, a seed-layer-forming step of forming a seed layer 24 is performed. The seed layer 24 is formed on at least a portion of the adhesive layer 31 that is present in the through hole 15. The seed layer 24 may be present on the first surface 13.

The seed layer 24 is formed by physical film forming such as vapor deposition, sputtering, or ion plating. As illustrated in Fig. 7, a portion of the seed layer 24 that is present in the through hole 15 does not reach the second surface 14 in the thickness direction D3. In the example illustrated in Fig. 7, the seed layer 24 is formed such that the fourth end 242 thereof is located on the adhesive layer 31.

In the thickness direction D3, a portion of the seed layer 24 that is present in the through hole 15 has a dimension T21, which is smaller than the dimension T11 of the adhesive layer 31. The numerical range of the dimension T21 may be the same as the numerical range of the thickness H1 described above. The numerical range of T21/TO, representing the ratio of the dimension T21 to the thickness T0 of the substrate 12, may be the same as the numerical range of H1/TO described above.

An exemplary method of adjusting the dimension T21 of the seed layer 24 will now be described.

The following describes a method of forming a seed layer 24 by vapor deposition. In vapor deposition, the material for the seed layer 24 flies toward the first surface 13. Accordingly, as illustrated in Fig. 7, a seed layer 24 is formed in such a manner as to extend from the first surface 13 along the wall surface 16 toward the second surface 14. The seed layer 24 is formed on the first surface 13 as well. Adjusting factors such as the duration of vapor deposition and/or the angle of incidence enables controlling the depth to which the seed layer 24 enters from the first surface 13 into the through hole 15, that is, the dimension T21 of the seed layer 14.

Now, a method of forming a seed layer 24 by sputtering or ion plating will be described. First, sputtering or ion plating for forming a seed layer 24 is performed from the side of the first surface 13. Accordingly, a seed layer 24 is formed in such a manner as to extend from the first surface 13 into the through hole 15 along the wall surface 16 toward the second surface 14. The dimension of the seed layer 24 in the thickness direction D3 is greater than a desired dimension T21. Subsequently, a resist layer is formed on a portion of the seed layer 24 that is present inside the through hole 15 and that has the desired dimension T21. Subsequently, an etching solution is supplied into the through hole 15 from the side of the second surface 14. Accordingly, the portion of the seed layer 24 that is not covered with the resist layer is removed. Thus, a seed layer 24 having the desired dimension T21 is formed inside the through hole 15.

The seed layer 24 has a thickness T22 of 5 nm or more, for example. The thickness T22 may be 10 nm or more, 15 nm or more, or 20 nm or more. The thickness T22 of the seed layer 24 is 50 nm or less, for example, and may be 40 nm or less or 30 nm or less. Setting the thickness T22 of the seed layer 24 to 5 nm or more can reduce the occurrence of defects such as pinholes therein. Setting the thickness T22 of the seed layer 24 to 50 nm or less can suppress nonuniformity in the thickness of the first layer 21. Accordingly, the production of the dent 232 is suppressed. The thickness T22 of the seed layer 24 is defined at the center of the first layer 21 in the thickness direction D3.

### (First Electroplating Step)

Subsequently, the first electroplating step of forming a first layer 21 by electroplating is performed. In the first electroplating step, a first plating solution is supplied to the first surface 13. As illustrated in Fig. 8, a first layer 21 that covers the seed layer 24 is formed by electroplating. The seed layer 24 functions as a cathode. The first layer 21 is formed not only inside the through hole 15 but also on the first surface 13.

The first layer 21 includes an interface 23 inside the through hole 15. The interface 23 may have a dent 232, which is depressed toward the first surface 13.

As illustrated in Fig. 8, the first layer 21 covers the fourth end 242 of the seed layer 24 in the thickness direction D3. Reference sign ΔT21 denotes the distance in the thickness direction D3 between the fourth end 242 of the seed layer 24 and the interfacial end 231 of the interface 23. The distance ΔT21 is 50 nm or less, for example, and may be 40 nm or less or 30 nm or less. That is, the distance ΔT21 is smaller than the thickness T0 of the substrate 12. The position of the fourth end 242 of the seed layer 24 can be estimated from the position of the interfacial end 231. The position of the interface 23 can be detected on the basis of a sectional image of the through hole 15.

The first electroplating step is performed such that the through hole 15 is covered with the first layer 21 at the first surface 13. The interface 23 laterally extends across the through hole 15.

The first plating solution may contain an electrically conductive material such as Cu, Au, Ag, Pt, Rh, Ni, Cr, Nb, Pb, Ta, Sn, In, or Al. The concentration, in the first plating solution, of an element that constitutes the electrically conductive material to be contained in the first layer 21 is also referred to as a first concentration. The electric current that is supplied to the seed layer 24 in the first electroplating step is also referred to as a first current.

The first plating solution may contain an accelerator that accelerates the precipitation reaction. The first plating solution may contain a retardant that retards the precipitation reaction.

### (Second Electroplating Step)

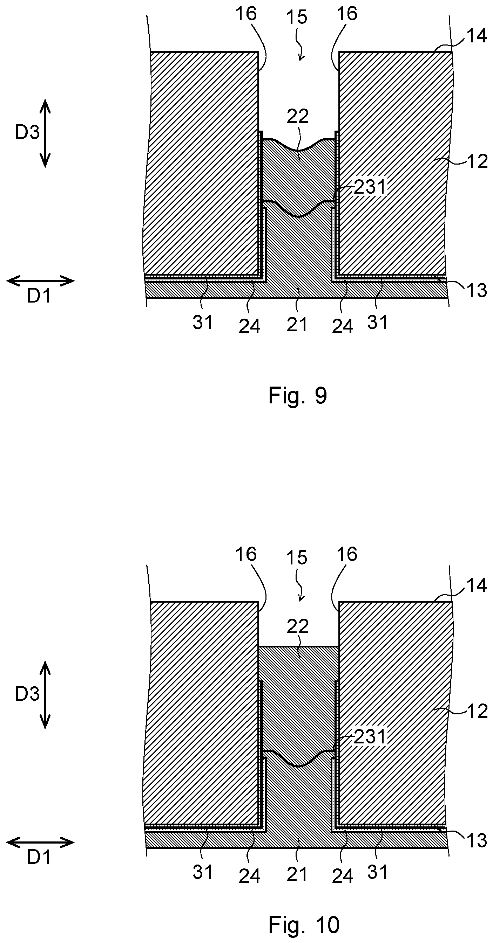

Subsequently, the second electroplating step of forming a second layer 22 by electroplating is performed. In the second electroplating step, a second plating solution is supplied to the second surface 14. Figs. 9 to 11 illustrate how the second layer 22 grows.

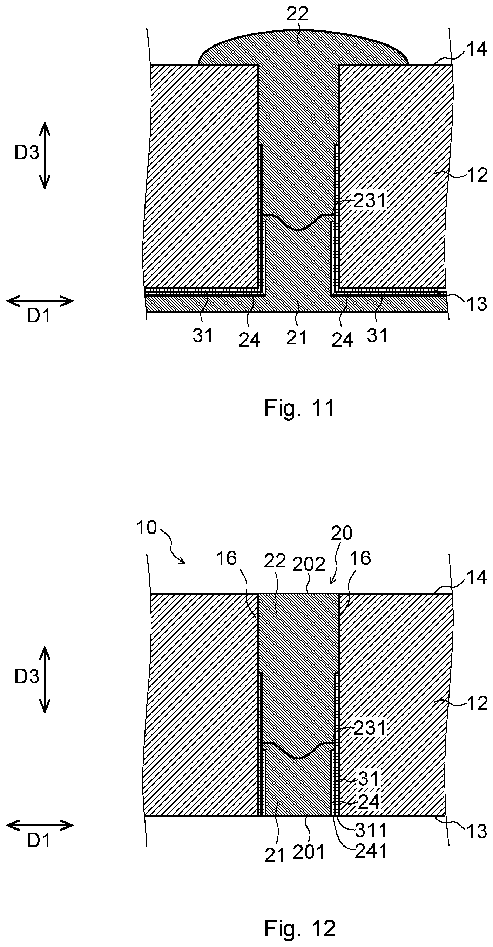

Between the first layer 21 and the second surface 14, no seed layer is present on either the adhesive layer 31 or the wall surface 16. In such a case, the second layer 22 grows from the first layer 21 toward the second surface 14 in the thickness direction D3. Therefore, the occurrence of any defects, such as voids, in the second layer 22 can be suppressed more than in a case where the second layer 22 grows in the planar direction from the wall surface 16 toward the center of the through hole 15. Fig. 11 is a sectional view illustrating a state where the second layer 22 has grown beyond the second surface 14.

As with the first plating solution, the second plating solution may contain an electrically conductive material such as Cu, Au, Ag, Pt, Rh, Ni, Cr, Nb, Pb, Ta, Sn, In, or Al. The concentration, in the second plating solution, of an element that constitutes the electrically conductive material to be contained in the second layer 22 is also referred to as a second concentration. The electric current that is supplied to the seed layer 24 in the second electroplating step is also referred to as a second current.

The second concentration may be lower than the first concentration. Such a relationship can suppress the occurrence of any defects, such as voids, in the second layer 22.

The second current may be lower than the first current. Such a relationship can suppress the occurrence of any defects, such as voids, in the second layer 22.

The second plating solution may contain an accelerator that accelerates the precipitation reaction. The concentration of the accelerator contained in the second plating solution may be lower than the concentration of the accelerator contained in the first plating solution.

The second plating solution may contain a retardant that retards the precipitation reaction. The concentration of the retardant contained in the second plating solution may be higher than the concentration of the retardant contained in the first plating solution.

### (Removal Step)

Subsequently, a removal step of removing unnecessary layers may be performed. Consequently, as illustrated in Fig. 12, a through-via substrate 10 including an adhesive layer 31, a seed layer 24, a first layer 21, and a second layer 22 that are located inside the through hole 15 is obtained.

For example, as illustrated in Fig. 12, a first removal step of removing a portion of the first layer 21 that is present on the first surface 13 may be performed. In the first removal step, chemical mechanical grinding may be employed to remove the portion of the first layer 21 that is present on the first surface 13. In the first removal step, a portion of the seed layer 24 that is present on the first surface 13 may be removed. In the first removal step, a portion of the adhesive layer 31 that is present on the first surface 13 may be removed. The first removal step may form a first end face 201, which is flush with the first surface 13.

For example, as illustrated in Fig. 12, a second removal step of removing a portion of the second layer 22 that is present on the second surface 14 may be performed. In the second removal step, chemical mechanical grinding may be employed to remove the portion of the second layer 22 that is present on the second surface 14. The second removal step may form a second end face 202, which is flush with the second surface 14.

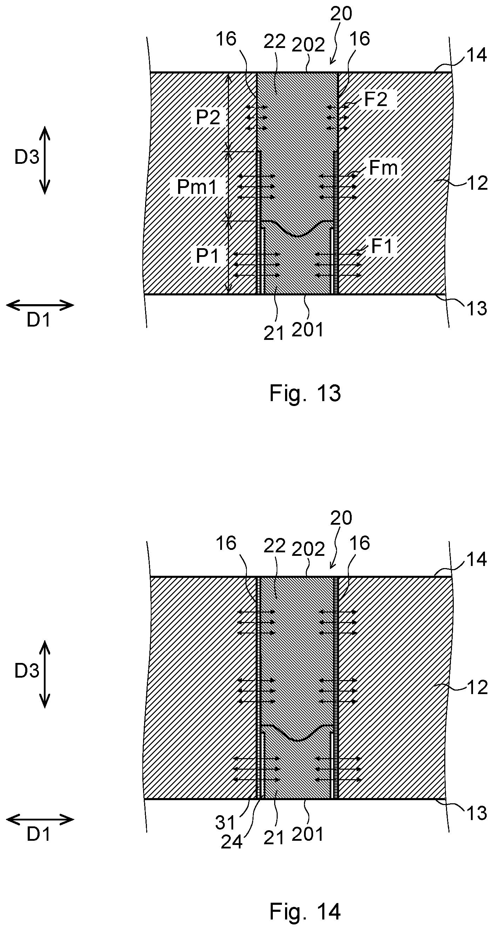

Fig. 13 is a diagram for describing an exemplary advantageous effect produced in the through-via substrate 10. In Fig. 13, reference signs F1, Fm, and F2 denote a thermal stress that occurs in the first portion P1, a thermal stress that occurs in the first middle portion Pm1, and a thermal stress that occurs in the second portion P2, respectively. The thermal stress Fm that occurs in the first middle portion Pm1 is expected to be smaller than the thermal stress F1 that occurs in the first portion P1. The thermal stress F2 that occurs in the second portion P2 is expected to be smaller than the thermal stress Fm that occurs in the first middle portion Pm1. The thermal stresses that occur in the through via 20 decrease in a graded manner in the thickness direction D3. Therefore, the occurrence of any damage, such as cracks, to the substrate 12 or the through via 20 is suppressed.

Fig. 14 illustrates a through-via substrate 10 according to a first comparative embodiment. The through-via substrate 10 illustrated in Fig. 14 is different from the through-via substrate 10 illustrated in Fig. 13 in that the adhesive layer 31 extends over the entirety of the wall surface 16.

In the through-via substrate 10 illustrated in Fig. 14, a relatively large thermal stress occurs over the entirety of the second layer 22. Therefore, the thermal stress that occurs in the first layer 21 may not appropriately be dispersed in the second layer 22. In contrast, in the through-via substrate 10 illustrated in Fig. 13, the second portion P2 can appropriately disperse the thermal stress that occurs in the first portion P1.

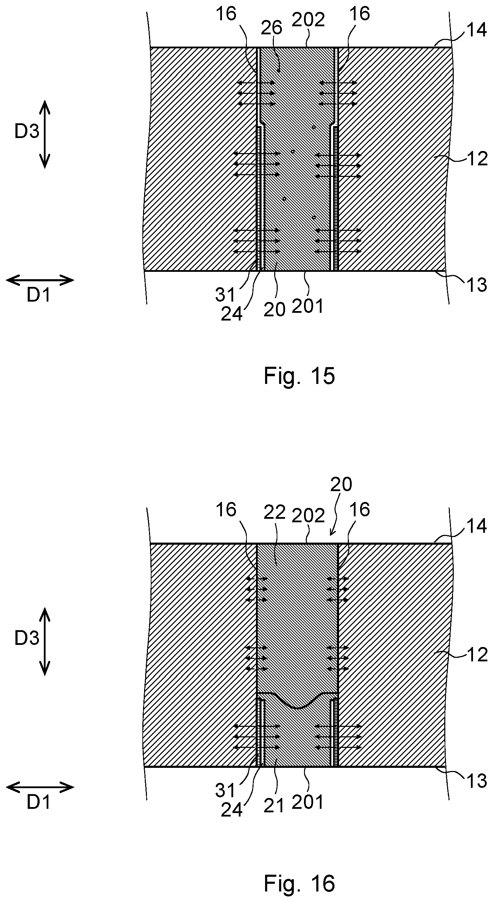

Fig. 15 illustrates a through-via substrate 10 according to a second comparative embodiment. The through-via substrate 10 illustrated in Fig. 15 is different from the through-via substrate 10 illustrated in Fig. 13 in that the seed layer 24 extends over the entirety of the wall surface 16.

In the case of the through-via substrate 10 illustrated in Fig. 15, the electroplating step grows the through via 20 in the planar direction from the wall surface 16 toward the planar-direction center of the through hole 15 in the entire area of the through hole 15. Consequently, defects such as voids tend to occur in the through via 20. In contrast, in the case of the through-via substrate 10 illustrated in Fig. 13, since the second layer 22 grows in the thickness direction D3 from the first layer 21 toward the second surface 14, the occurrence of any defects, such as voids, in the second layer 22 can be suppressed.

In the through-via substrate 10 illustrated in Fig. 15, a relatively large thermal stress occurs in the through via 20 even at a location where the adhesive layer 31 is absent. Consequently, the thermal stress that occurs in the through via 20 at a location where the adhesive layer 31 is present may not appropriately be dispersed. In contrast, in the through-via substrate 10 illustrated in Fig. 13, the second portion P2 can appropriately disperse the thermal stress that occurs in the first portion P1.

Fig. 16 illustrates a through-via substrate 10 according to a third comparative embodiment. The through-via substrate 10 illustrated in Fig. 16 is different from the through-via substrate 10 illustrated in Fig. 13 in that both the adhesive layer 31 and the seed layer 24 are covered with the first layer 21.

In the through-via substrate 10 illustrated in Fig. 16, a relatively small thermal stress occurs over the entirety of the second layer 22. Consequently, the thermal stress may change sharply between the first layer 21 and the second layer 22. In contrast, in the through-via substrate 10 illustrated in Fig. 13, the first middle portion Pm1 can moderate such a sharp change in the thermal stress.

The above embodiment can be changed in various ways. Such variations will now be described with reference to the drawings according to need. In the following description and the drawings to be referred to below, elements that can be configured as in the above embodiment are denoted by the same reference signs as those used for corresponding ones of the elements according to the first embodiment, and redundant description of such elements is omitted. If it is obvious that the functional effects obtained by the above embodiment can also be obtained by the variations, description of such effects may be omitted.

### (First Variation)

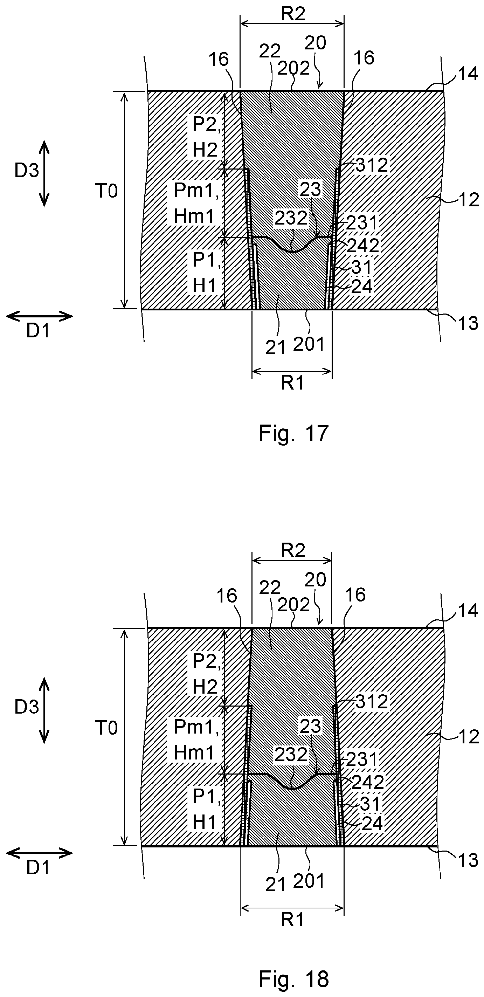

Fig. 17 is a sectional view illustrating a variation of the through hole 15. The dimension R1 of the through hole 15 at the first surface 13 may be smaller than the dimension R2 of the through hole 15 at the second surface 14. The dimension of the through hole 15 may increase from the first surface 13 toward the second surface 14. In the variation illustrated in Fig. 17, the aspect ratio of the through hole 15 is calculated as TO/R1.

### (Second Variation)

Fig. 18 is a sectional view illustrating a variation of the through hole 15. The dimension R1 of the through hole 15 at the first surface 13 may be greater than the dimension R2 of the through hole 15 at the second surface 14. The dimension of the through hole 15 may decrease from the first surface 13 toward the second surface 14. In the variation illustrated in Fig. 18, the aspect ratio of the through hole 15 is calculated as TO/R2.

### (Third Variation)

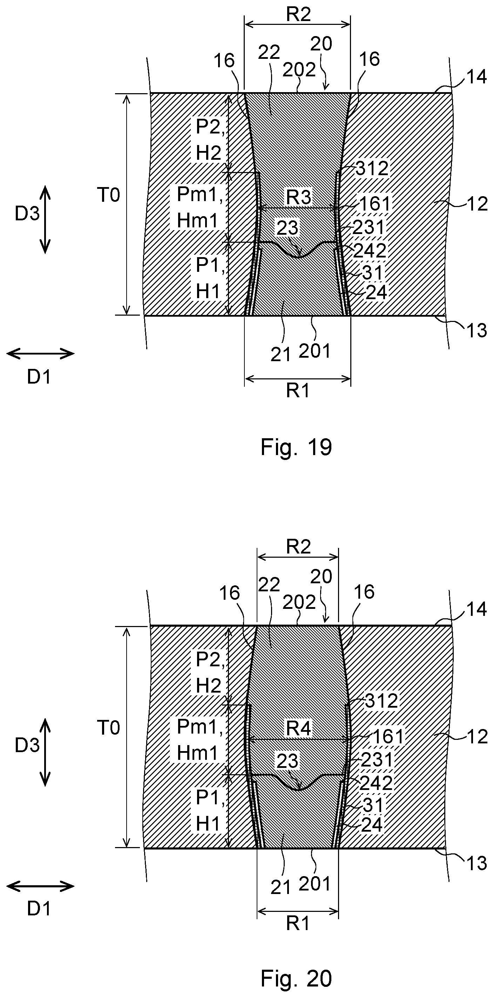

Fig. 19 is a sectional view illustrating a variation of the through hole 15. The through hole 15 may include a portion where the dimension thereof changes with the position in the thickness direction D3. For example, the through hole 15 may include a portion where the dimension thereof decreases from the first surface 13 toward the center position of the substrate 12 in the thickness direction D3. Furthermore, the through hole 15 may include a portion where the dimension thereof decreases from the second surface 14 toward the center position of the substrate 12 in the thickness direction D3. In such a variation, the dimension of the through hole 15 is minimum at a central part 161 of the substrate 12 that is defined in the thickness direction D3. The term "center position" refers to a position in the thickness direction D3 that is at the same distance from the first surface 13 and from the second surface 14. The distance in the thickness direction D3 from the first surface 13 to the center position is equal to the distance in the thickness direction D3 from the second surface 14 to the center position. The term "central part" encompasses the center position of the substrate 12 in the thickness direction D3, a range from the center position to 0.1×T0 toward the first surface 13, and a range from the center position to 0.1×T0 toward the second surface 14. The minimum value for the dimension of the through hole 15 is denoted by reference sign R3. In the variation illustrated in Fig. 19, the aspect ratio of the through hole 15 is calculated as TO/R3.

### (Fourth Variation)

Fig. 20 is a sectional view illustrating a variation of the through hole 15. The through hole 15 may include a portion where the dimension thereof increases from the first surface 13 toward the center position of the substrate 12 in the thickness direction D3. Furthermore, the through hole 15 may include a portion where the dimension thereof increases from the second surface 14 toward the center position of the substrate 12 in the thickness direction D3. In such a variation, the dimension of the through hole 15 is maximum, a value R4, at the central part 161 of the substrate 12 that is defined in the thickness direction D3. The minimum value for the dimension of the through hole 15 may be the dimension R1 of the through hole 15 at the first surface 13 or the dimension R2 of the through hole 15 at the second surface 14.

### (Fifth Variation)

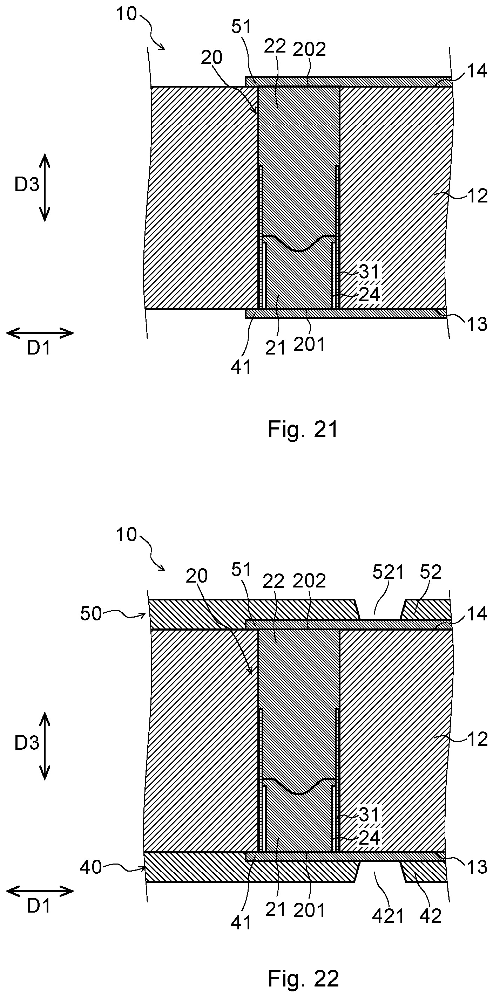

Fig. 21 is a sectional view illustrating a variation of the through-via substrate 10. The through-via substrate 10 may include a first conductive layer 41 connected to the first end face 201 of the through via 20. The first conductive layer 41 may be located on the first surface 13. The first conductive layer 41 may constitute a wire extending in one of the planar directions. The first conductive layer 41 may contain a metal material such as Cu, Au, Ag, Pt, Rh, Ni, Cr, or Pd. The first conductive layer 41 may contain a compound of any of the foregoing metal materials.

The through-via substrate 10 may include a second conductive layer 51 connected to the second end face 202 of the through via 20. The second conductive layer 51 may be located on the second surface 14. The second conductive layer 51 may constitute a wire extending in one of the planar directions. The second conductive layer 51 may contain a metal material such as Cu, Au, Ag, Pt, Rh, Ni, Cr, or Pd. The second conductive layer 51 may contain a compound of any of the foregoing metal materials.

As illustrated in Fig. 22, the through-via substrate 10 may include a first insulating layer 42 overlapping the first conductive layer 41 in the thickness direction D3. The first insulating layer 42 may include an opening 421 overlapping the first conductive layer 41. A stack including the first conductive layer 41 and the first insulating layer 42 is also referred to as a first wiring layer 40. The first wiring layer 40 is located at the first surface 13.

As illustrated in Fig. 22, the through-via substrate 10 may include a second insulating layer 52 overlapping the second conductive layer 51 in the thickness direction D3. The second insulating layer 52 may include an opening 521 overlapping the second conductive layer 51. A stack including the second conductive layer 51 and the second insulating layer 52 is also referred to as a second wiring layer 50. The second wiring layer 50 is located at the second surface 14.

### (Sixth Variation)

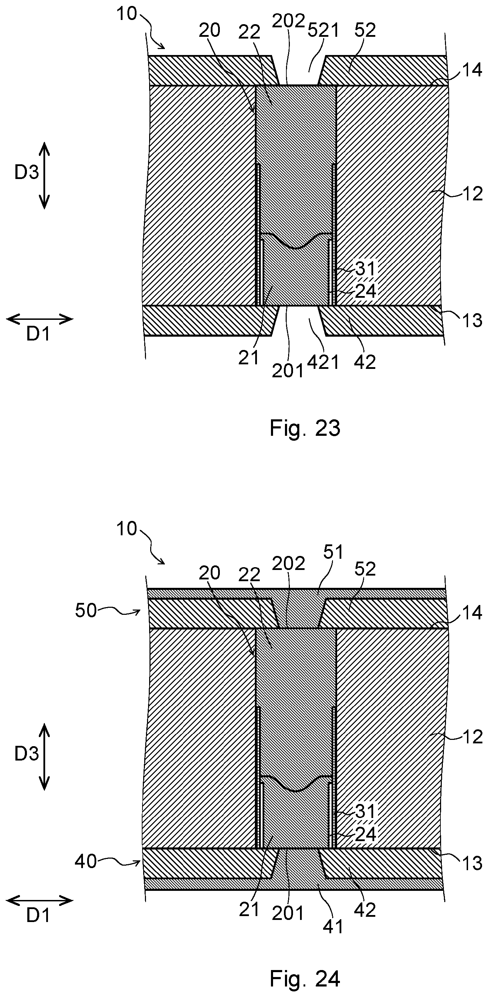

Fig. 23 is a sectional view illustrating a variation of the through-via substrate 10. The first insulating layer 42 may be located on the first surface 13. The first insulating layer 42 may include an opening 421 overlapping the through via 20.

The second insulating layer 52 may be located on the second surface 14. The second insulating layer 52 may include an opening 521 overlapping the through via 20.

As illustrated in Fig. 24, the first conductive layer 41 may be located on the first insulating layer 42. The first conductive layer 41 may include a portion located in the opening 421 of the first insulating layer 42. The portion of the first conductive layer 41 that is located in the opening 421 of the first insulating layer 42 may be connected to the first end face 201 of the through via 20.

As illustrated in Fig. 24, the second conductive layer 51 may be located on the second insulating layer 52. The second conductive layer 51 may include a portion located in the opening 521 of the second insulating layer 52. The portion of the second conductive layer 51 that is located in the opening 521 of the second insulating layer 52 may be connected to the second end face 202 of the through via 20.

### (Seventh Variation)

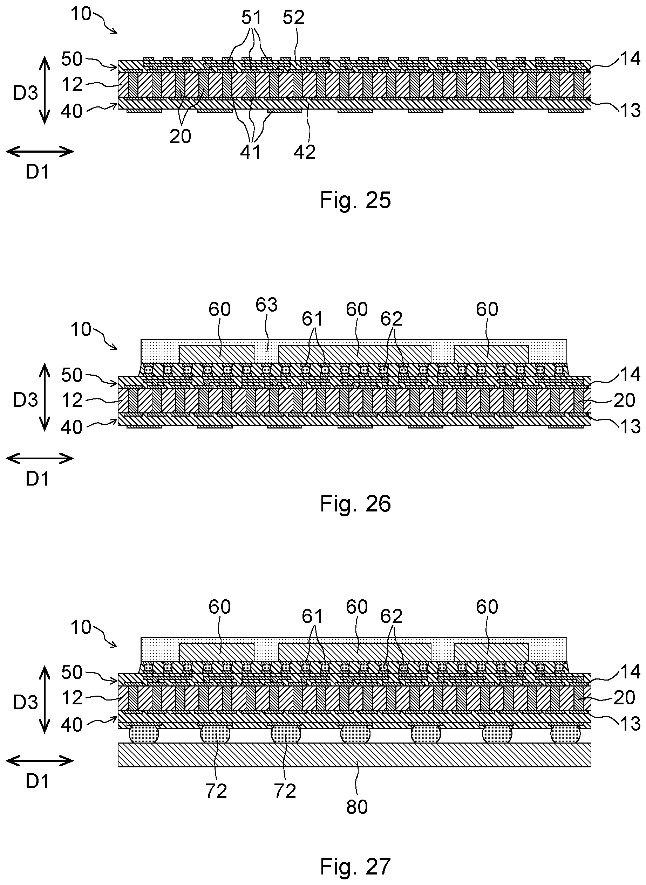

Fig. 25 is a sectional view illustrating a variation of the through-via substrate 10. The first wiring layer 40 may include a plurality of first conductive layers 41 and a first insulating layer 42 that are stacked in the thickness direction D3. The second wiring layer 50 may include a plurality of second conductive layers 51 and a second insulating layer 52 that are stacked in the thickness direction D3.

### (Eighth Variation)

Fig. 26 is a sectional view illustrating a variation of the through-via substrate 10. The through-via substrate 10 may include at least one semiconductor device 60. The through-via substrate 10 may include a plurality of semiconductor devices 60. The semiconductor device 60 may be an LSI chip such as a logic IC or a memory IC. The semiconductor device 60 may be a MEMS (Micro Electro Mechanical Systems) chip. The MEMS chip is an electronic device in which a mechanical component, a sensor, an actuator, an electronic circuit, and so forth are integrally mounted on a single substrate.

As illustrated in Fig. 26, the semiconductor device 60 may be provided facing the second surface 14. The semiconductor device 60 may be provided facing the first surface 13, although not illustrated. The semiconductor device 60 may be covered with molding resin 63.

The semiconductor device 60 includes a terminal 61. The terminal 61 may be electrically connected to the through via 20. For example, the terminal 61 may be electrically connected to the through via 20 with a bump 62 and the second conductive layer 51 of the second wiring layer 50 interposed in between.

### (Ninth Variation)

Fig. 27 is a sectional view illustrating a variation of the through-via substrate 10. The through-via substrate 10 may include a plurality of bumps 72. The bumps 72 may be located opposite the semiconductor device 60 in the thickness direction D3. For example, in the case where the semiconductor device 60 is located on the second wiring layer 50, the bumps 72 may be located on the first wiring layer 40. The bumps 72 may be connected to the first conductive layer 41 of the first wiring layer 40.

The plurality of bumps 72 may constitute a ball grid array. The through-via substrate 10 including the plurality of bumps 72 may constitute a semiconductor package. The semiconductor package constituted by the through-via substrate 10 may be mounted on a motherboard 80 with the plurality of bumps 72 interposed in between.

### (Tenth Variation)

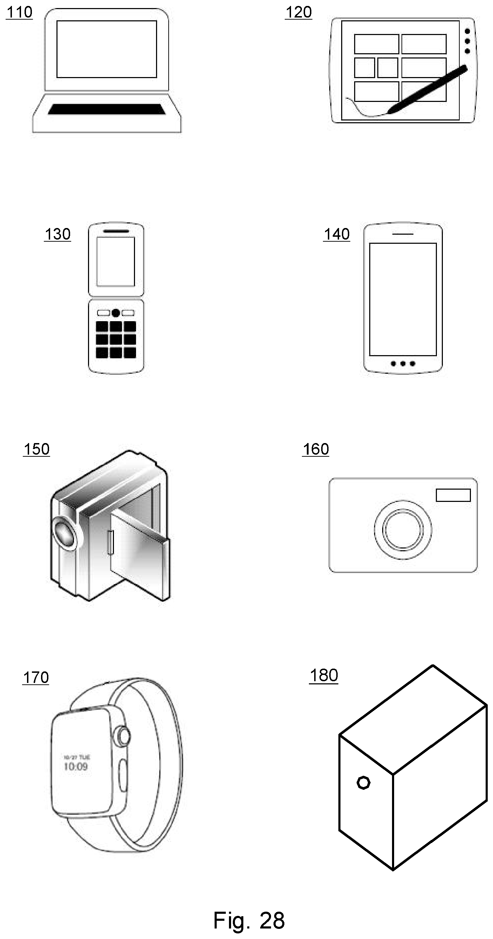

Fig. 28 illustrates exemplary products that can include the through-via substrate 10 according to an embodiment of the present disclosure. The through-via substrate 10 according to an embodiment of the present disclosure can be used in various products. For example, the through-via substrate 10 is included in any of a laptop personal computer 110, a tablet terminal 120, a mobile phone 130, a smartphone 140, a digital video camera 150, a digital camera 160, a digital watch 170, a server 180, and so forth.

While some variations of the first embodiment have been described, some of the variations can be combined according to need to be applied to the first embodiment, of course.

### (Second Embodiment)

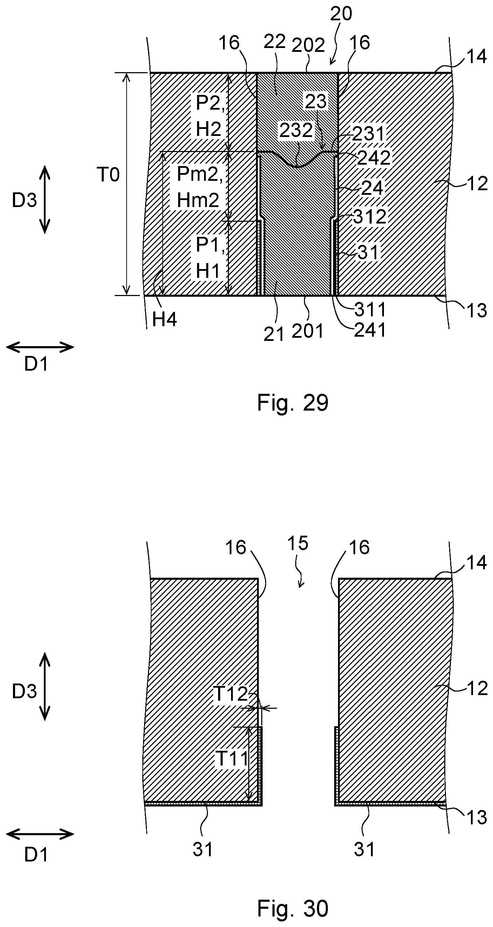

A second embodiment of the present disclosure will now be described with reference to Figs. 29 to 33. Redundant description of those of the elements according to the second embodiment that are configured the same as in the first embodiment is omitted. If it is obvious that the functional effects obtained by the first embodiment can also be obtained by the second embodiment, redundant description of such effects may be omitted.

Fig. 29 is a sectional view illustrating an exemplary through hole 15. As with the case of the first embodiment, the adhesive layer 31 extends in the thickness direction D3 along the wall surface 16 toward the second surface 14 in such a manner as not to reach the second surface 14. As with the case of the first embodiment, the seed layer 24 extends in the thickness direction D3 along the wall surface 16 toward the second surface 14 in such a manner as not to reach the second surface 14.

Unlike the case of the first embodiment, the seed layer 24 of the through via 20 is located closer to the second surface 14 than the second end 312 of the adhesive layer 31. In other words, the fourth end 242 is located between the second surface 14 and the second end 312 in the thickness direction D3. The seed layer 24 covers the second end 312 of the adhesive layer 31.

The interface 23 between the first layer 21 and the second layer 22 is located between the second surface 14 and the second end 312 of the adhesive layer 31 in the thickness direction D3. The through via 20 is sectioned into a second middle portion Pm2, a first portion P1, and a second portion P2 in the thickness direction D3 with reference to the interfacial end 231 of the interface 23 and the second end 312 of the adhesive layer 31. As with the first middle portion Pm1, the second middle portion Pm2 is a portion of the through via 20 that is located between the interfacial end 231 of the interface 23 and the second end 312 of the adhesive layer 31 in the thickness direction D3. The first portion P1 is a portion of the through via 20 that is located between the first surface 13 and the second middle portion Pm2 in the thickness direction D3. In the example illustrated in Fig. 29, the first portion P1 is located between the first surface 13 and the second end 312 of the adhesive layer 31. The second portion P2 is a portion of the through via 20 that is located between the second surface 14 and the second middle portion Pm2 in the thickness direction D3. In the example illustrated in Fig. 29, the second portion P2 is located between the second surface 14 and the interfacial end 231 of the interface 23.

In the first portion P1, the adhesive layer 31 and the seed layer 24 are present between the through via 20 and the wall surface 16. In most part of the second middle portion Pm2, the seed layer 24 is present between the through via 20 and the wall surface 16. In the second portion P2, neither the adhesive layer 31 nor the seed layer 24 is present between the through via 20 and the wall surface 16.

The adhesion of the through via 20 to the seed layer 24 is higher than the adhesion of the through via 20 to the wall surface 16. Accordingly, the force of adhesion between the wall surface 16 and the through via 20 in the second middle portion Pm2 is greater than the force of adhesion between the wall surface 16 and the through via 20 in the second portion P2.

The adhesion of the adhesive layer 31 to the wall surface 16 is higher than the adhesion of the seed layer 24 to the wall surface 16. Accordingly, the force of adhesion between the wall surface 16 and the through via 20 in the first portion P1 is greater than a force of adhesion A between the wall surface 16 and the through via 20 in the second middle portion Pm2.

The second middle portion Pm2 has a thickness Hm2. The thickness Hm2 is the distance in the thickness direction D3 between the interfacial end 231 of the interface 23 and the second end 312 of the adhesive layer 31. The first portion P1 has a thickness H1. In the example illustrated in Fig. 29, the thickness H1 is the distance in the thickness direction D3 between the first surface 13 and the second end 312 of the adhesive layer 31. The second portion P2 has a thickness H2. In the example illustrated in Fig. 29, the thickness H2 is the distance in the thickness direction D3 between the second surface 14 and the interfacial end 231 of the interface 23.

The thickness H1 of the first portion P1 is 2 µm or more, for example, and may be 5 µm or more, 10 µm or more, 30 µm or more, 50 µm or more, or 100 µm or more. Setting the thickness H1 to a predetermined value or more can appropriately increase the adhesion between the through via 20 and the wall surface 16. The thickness H1 is 250 µm or less, for example, and may be 200 µm or less, 150 µm or less, 130 µm or less, 100 µm or less, 50 µm or less, or 40 µm or less. Setting the thickness H1 to 250 µm or less can suppress excessive increase in the adhesion of the through via 20 to the wall surface 16.

The thickness H1 of the first portion P1 may be determined relative to the thickness T0 of the substrate 12. H1/T0, representing the ratio of the thickness H1 to the thickness TO, is 0.005 or more, for example, and may be 0.010 or more, 0.025 or more, 0.050 or more, 0.075 or more, 0.10 or more, 0.15 or more, or 0.20 or more. H1/T0 is 0.50 or less, for example, and may be 0.40 or less, 0.30 or less, 0.25 or less, 0.20 or less, 0.15 or less, 0.10 or less, or 0.075 or less.

The thickness H2 of the second portion P2 is 50 µm or more, for example, and may be 100 µm or more, 200 µm or more, or 300 µm or more. Setting the thickness H2 to 50 µm or more can appropriately disperse the thermal stress that occurs in the through via 20. The thickness H2 is 995 µm or less, for example, and may be 950 µm or less, 500 µm or less, 350 µm or less, 250 µm or less, or 200 µm or less.

The thickness H2 of the second portion P2 may be determined relative to the thickness T0 of the substrate 12. H2/T0, representing the ratio of the thickness H2 to the thickness TO, is 0.10 or more, for example, and may be 0.15 or more, 0.20 or more, 0.40 or more, 0.60 or more, or 0.75 or more. H2/TO is 0.995 or less, for example, and may be 0.99 or less, 0.95 or less, 0.85 or less, 0.70 or less, 0.60 or less, 0.50 or less, 0.40 or less, or 0.30 or less.

The thickness Hm2 of the second middle portion Pm2 is 3 µm or more, for example, and may be 5 µm or more, 10 µm or more, 20 µm or more, 50 µm or more, or 100 µm or more. Setting the thickness Hm2 to a predetermined value or more can moderate the change in the thermal stress between the first portion P1 and the second portion P2. The thickness Hm2 is 250 µm or less, for example, and may be 200 µm or less, 150 µm or less, 100 µm or less, 50 µm or less., or 40 µm or less.

The thickness Hm2 of the second middle portion Pm2 may be determined relative to the thickness T0 of the substrate 12. Hm2/T0, representing the ratio of the thickness Hm2 to the thickness T0, is 0.003 or more, for example, and may be 0.005 or more, 0.010 or more, 0.020 or more, 0.050 or more, 0.075 or more, 0.10 or more, 0.15 or more, or 0.20 or more. Hm2/T0 is 0.50 or less, for example, and may be 0.40 or less or 0.30 or less.

The thickness H1 of the first portion P1, the thickness H2 of the second portion P2, and the thickness Hm2 of the second middle portion Pm2 may be set such that the three layers are well balanced. For example, the difference between the maximum value and the minimum value for each of H1/T0, H2/T0, and Hm2/TO may be 0.40 or less, 0.30 or less, or 0.20 or less.

In Fig. 29, reference sign H4 denotes the distance in the thickness direction D3 between the first surface 13 and the end of the second middle portion Pm2 that is closer to the second surface 14. In the example illustrated in Fig. 29, the distance H4 is the distance in the thickness direction D3 between the first surface 13 and the interfacial end 231 of the interface 23. H4/T0, representing the ratio of the distance H4 to the thickness T0 of the substrate 12, is 0.005 or more, for example, and may be 0.01 or more, 0.02 or more, 0.05 or more, 0.10 or more, 0.15 or more, 0.30 or more, 0.50 or more, 0.70 or more, 0.75 or more, or 0.80 or more. H4/TO is 0.95 or less, for example, and may be 0.92 or less, 0.90 or less, 0.80 or less, 0.60 or less, 0.40 or less, 0.25 or less, or 0.15 or less.

The ratio H2/TO of the thickness H2 to the thickness T0 may be greater than the ratio H4/T0 of the distance H4 to the thickness T0. In other words, the second portion P2 may occupy a space greater than half the size of the through hole 15 in the thickness direction D3. The thermal stress attributed to the difference between the coefficient of thermal expansion of the through via 20 and the coefficient of thermal expansion of the substrate 12 tends to be smaller in the second portion P2 than in the first portion P1 and in the second middle portion Pm2. Setting the thickness H1 of the first portion P1 to a predetermined value or more while increasing the proportion of the second portion P2 in the through hole 15 enables the second portion P2 to more assuredly absorb the thermal stress that occurs in the first portion P1.

The value subtracting H4 from H2 is expressed as ΔH24. ΔH24/T0, representing the ratio of the difference ΔH24 to the thickness T0, is 0.10 or more, for example, and may be 0.20 or more, 0.25 or more, 0.30 or more, or 0.50 or more. ΔH24/T0 is 0.99 or less, for example, and may be 0.98 or less, 0.95 or less, 0.90 or less, 0.80 or less, 0.75 or less, or 0.70 or less.

### (Method of Manufacturing Through-Via Substrate)

An exemplary method of manufacturing the through-via substrate 10 will now be described with reference to Figs. 30 to 32.

As with the case of the first embodiment, a substrate 12 including a through hole 15 is prepared. Subsequently, as illustrated in Fig. 30, an adhesive-layer-forming step of forming an adhesive layer 31 is performed. In the thickness direction D3, the dimension T11 of a portion of the adhesive layer 31 that is present in the through hole 15 is smaller than the thickness T0 of the substrate 12. The numerical range of the dimension T11 may be the same as the numerical range of H1 described above. The numerical range of T11/T0, representing the ratio of the dimension T11 to the thickness T0 of the substrate 12, may be the same as the numerical range of H1/TO described above.

### (Seed-Layer-Forming Step)

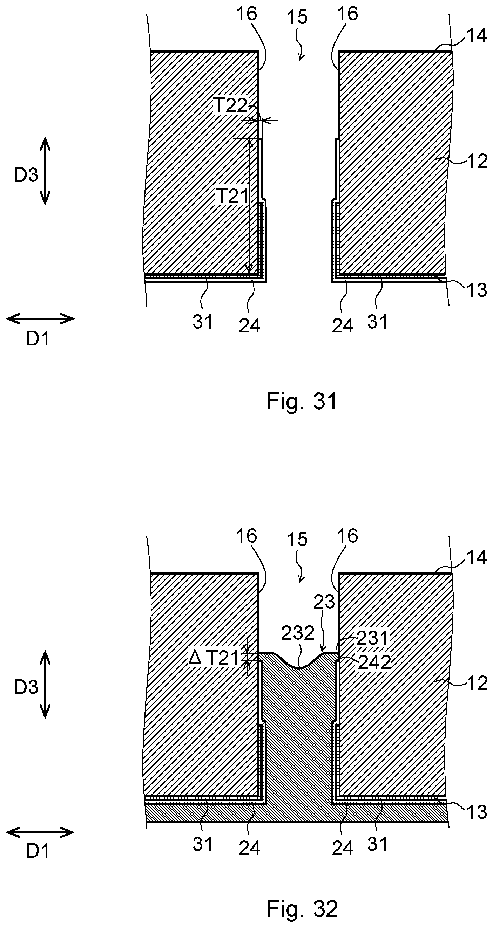

Subsequently, as illustrated in Fig. 31, a seed-layer-forming step of forming a seed layer 24 is performed. The seed layer 24 is formed over the adhesive layer 31 and the wall surface 16 in such a manner as to cover the second end 312 of the adhesive layer 31. In the thickness direction D3, the dimension T21 of a portion of the seed layer 24 that is present in the through hole 15 is greater than the dimension T11 of the adhesive layer 31. The numerical range of the ratio T21/T0 of the dimension T21 to the thickness T0 of the substrate 12 may be the same as the numerical range of H4/T0 described above.

### (First Electroplating Step)

Subsequently, as illustrated in Fig. 32, a first electroplating step of forming a first layer 21 by electroplating is performed. A first layer 21 that covers the seed layer 24 is formed by electroplating.

Subsequently, as with the case of the first embodiment, a second electroplating step and a removal step are performed. Consequently, a through-via substrate 10 including an adhesive layer 31, a seed layer 24, a first layer 21, and a second layer 22 that are located inside the through hole 15 is obtained.

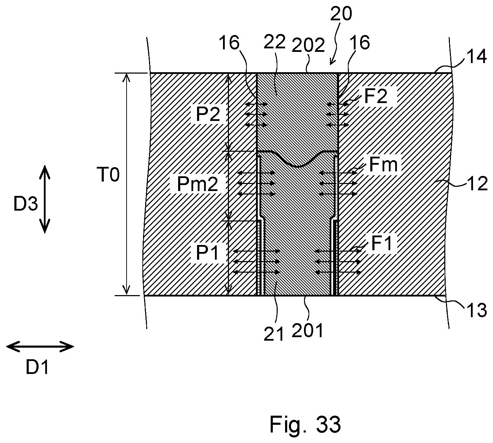

Fig. 33 is a diagram for describing an exemplary advantageous effect produced in the through-via substrate 10. In Fig. 33, reference signs F1, Fm, and F2 denote a thermal stress that occurs in the first portion P1, a thermal stress that occurs in the second middle portion Pm2, and a thermal stress that occurs in the second portion P2, respectively. The thermal stress Fm that occurs in the second middle portion Pm2 is expected to be smaller than the thermal stress F1 that occurs in the first portion P1. The thermal stress F2 that occurs in the second portion P2 is expected to be smaller than the thermal stress Fm that occurs in the second middle portion Pm2. The thermal stresses that occur in the through via 20 decrease in a graded manner in the thickness direction D3. Therefore, the occurrence of any damage, such as cracks, to the substrate 12 or the through via 20 is suppressed.

The above first to tenth variations of the first embodiment may be applied to the second embodiment. A plurality of variations may be combined as appropriate to be applied to the second embodiment.

### [EXAMPLES]

Now, the embodiments of the present disclosure will further be described specifically with working examples. Embodiments of the present disclosure is not limited to the following working examples, without departing from the essence thereof.

### (WORKING EXAMPLE A1)

A glass substrate having a thickness T0 of 400 µm was prepared as a substrate 12. Subsequently, a through hole 15, illustrated in Fig. 2A, was made in the substrate 12. The dimension of the through hole 15 in the first direction D1 was 70 µm.

Subsequently, an adhesive layer 31 and a through via 20 according to the above first embodiment were formed in the through hole 15. Consequently, a through-via substrate 10 was obtained. The through via 20 included a first portion P1, a second portion P2, and a first middle portion Pm1. The interface 23 between the first layer 21 and the second layer 22 was located between the first surface 13 and the second end 312 of the adhesive layer 31 in the thickness direction D3.

The thickness H1 of the first portion P1 was 5 µm. The thickness Hm1 of the first middle portion Pm1 was 45 µm. The distance H3 in the thickness direction D3 between the first surface 13 and the second end 312 of the adhesive layer 31 was 50 µm. The thickness H2 of the second portion P2 was 350 µm.

The reliability of the through-via substrate 10 was evaluated.

In the reliability evaluation, the through-via substrate 10 is subjected to 1000 heat cycles, and then the appearance of the through-via substrate 10 is observed. Specifically, it is evaluated whether there are any defects, such as cracks and gaps, in the appearance of the through via 20 of the through-via substrate 10. If any defects such as cracks and gaps are observed, the through-via substrate 10 under evaluation is determined to be "No Good". If no defects such as cracks and gaps are observed, the through-via substrate 10 is further subjected to 1000 heat cycles. Then, the appearance of the through-via substrate 10 is observed. If any defects such as cracks and gaps are observed after the total of 2000 heat cycles, the through-via substrate 10 under evaluation is determined to be "Good". If no defects such as cracks and gaps are observed after the total of 2000 heat cycles, the through-via substrate 10 under evaluation is determined to be "Excellent".

A single heat cycle includes a temperature-raising step, a high-temperature-maintaining step, a temperature-lowering step, and a low-temperature-maintaining step. The temperature-raising step is a step of changing the environment around the through-via substrate 10 from -55°C to +125°C in 30 minutes. The high-temperature-maintaining step is a step of maintaining the environment around the through-via substrate 10 at +125°C for 30 minutes. The temperature-lowering step is a step of changing the environment around the through-via substrate 10 from +125°C to -55°C in 30 minutes. The low-temperature-maintaining step is a step of maintaining the environment around the through-via substrate 10 at -55°C for 30 minutes.

The through-via substrate 10 of Working Example A1 had no defects after 1000 heat cycles but caused some defect after 2000 heat cycles. The through-via substrate 10 of Working Example A1 was determined to be "Good".

### (WORKING EXAMPLES A2 to A10)

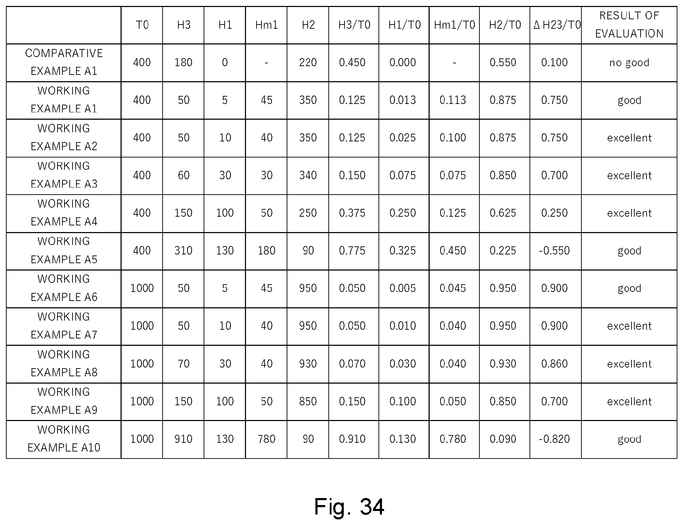

Respective through-via substrates 10 were prepared by varying at least one of the thickness H1 of the first portion P1, the thickness Hm1 of the first middle portion Pm1, the thickness H2 of the second portion P2, and the thickness T0 of the substrate 12 from the value for Working Example A1. Subsequently, as with the case of Working Example A1, the reliability of each of the through-via substrates 10 was evaluated. The results are summarized in Fig. 34.

### (Comparative Example A1)

While no adhesive layer 31 was formed in the through hole 15, a through via 20 was formed in the through hole 15. In Comparative Example A1, the dimension of the seed layer 24 in the thickness direction D3 was measured as the distance H3. Subsequently, as with the case of Working Example A1, the reliability of the through-via substrate 10 was evaluated.

In the through-via substrate 10 of Comparative Example A1, a gap occurred between the wall surface 16 of the through hole 15 and the through via 20 after 1000 heat cycles. The through-via substrate 10 of Comparative Example A1 was determined to be "No Good".

As summarized in Fig. 34, with a through via 20 including a first portion P1, a second portion P2, and a first middle portion Pm1, the occurrence of any detects such as cracks and gaps was suppressed. In particular, as demonstrated by Working Examples A2 to A4 and A7 to A9, when the thickness H1 of the first portion P1 was 10 µm or more and H2/T0 was greater than H3/T0, the through-via substrate 10 endured 2000 heat cycles.

### (WORKING EXAMPLE B1)

A glass substrate having a thickness T0 of 400 µm was prepared as a substrate 12. Subsequently, a through hole 15, illustrated in Fig. 29, was made in the substrate 12. The dimension of the through hole 15 in the first direction D1 was 70 µm.

Subsequently, an adhesive layer 31 and a through via 20 according to the above second embodiment were formed in the through hole 15. Consequently, a through-via substrate 10 was obtained. The through via 20 included a first portion P1, a second portion P2, and a second middle portion Pm2. The interface 23 between the first layer 21 and the second layer 22 was located between the second surface 14 and the second end 312 of the adhesive layer 31 in the thickness direction D3.

The thickness H1 of the first portion P1 was 2 µm. The thickness Hm2 of the second middle portion Pm2 was 3 µm. The distance H4 in the thickness direction D3 between the first surface 13 and the interfacial end 231 of the interface 23 was 5 µm. The thickness H2 of the second portion P2 was 395 µm.

Subsequently, as with the case of Working Example A1, the reliability of the through-via substrate 10 was evaluated. The through-via substrate 10 of Working Example B1 had no defects after 1000 heat cycles but caused some defect after 2000 heat cycles. The through-via substrate 10 of Working Example B1 was determined to be "Good".

### (WORKING EXAMPLES B2 to B10)

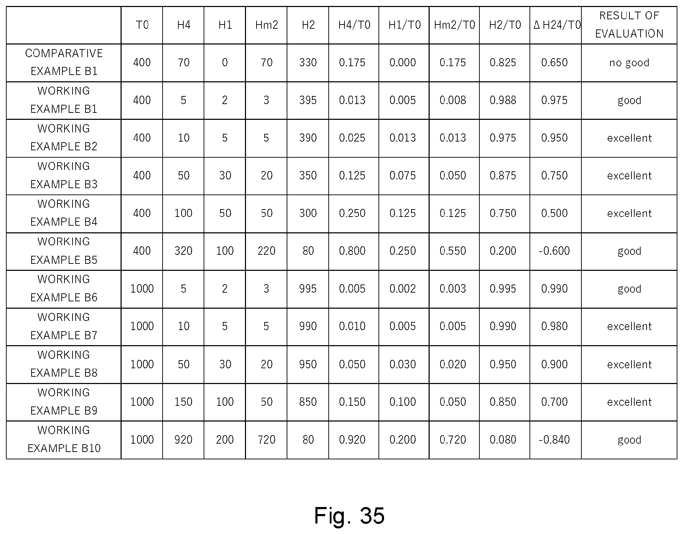

Respective through-via substrates 10 were prepared by varying at least one of the thickness H1 of the first portion P1, the thickness Hm2 of the second middle portion Pm2, the thickness H2 of the second portion P2, and the thickness T0 of the substrate 12 from the value for Working Example B1. Subsequently, as with the case of Working Example A1, the reliability of each of the through-via substrates 10 was evaluated. The results are summarized in Fig. 35.

### (Comparative Example B1)

While no adhesive layer 31 was formed in the through hole 15, a through via 20 was formed in the through hole 15. Subsequently, as with the case of Working Example A1, the reliability of the through-via substrate 10 was evaluated.

The through-via substrate 10 of Comparative Example B1 caused a gap between the wall surface 16 of the through hole 15 and the through via 20 after 1000 heat cycles. The through-via substrate 10 of Comparative Example B1 was determined to be "No Good".

As summarized in Fig. 35, with a through via 20 including a first portion P1, a second portion P2, and a second middle portion Pm2, the occurrence of any detects such as cracks and gaps was suppressed. In particular, as demonstrated by Working Examples B2 to B4 and B7 to B9, when the thickness H1 of the first portion P1 was 5 µm or more and H2/T0 was greater than H4/T0, the through-via substrate 10 endured 2000 heat cycles.

### (WORKING EXAMPLE B11)

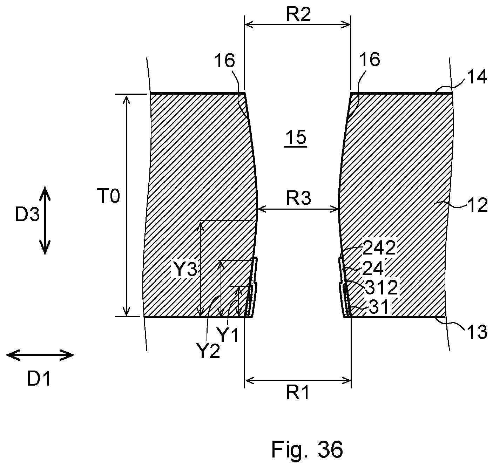

As with the case of Working Example B1, after a through hole 15 was made in a substrate 12, an adhesive layer 31 and a seed layer 24 according to the above second embodiment were formed in the through hole 15. Subsequently, the adhesive layer 31 and the seed layer 24 in the through hole 15 were observed through an electron microscope. Fig. 36 is a sectional view illustrating positions observed.

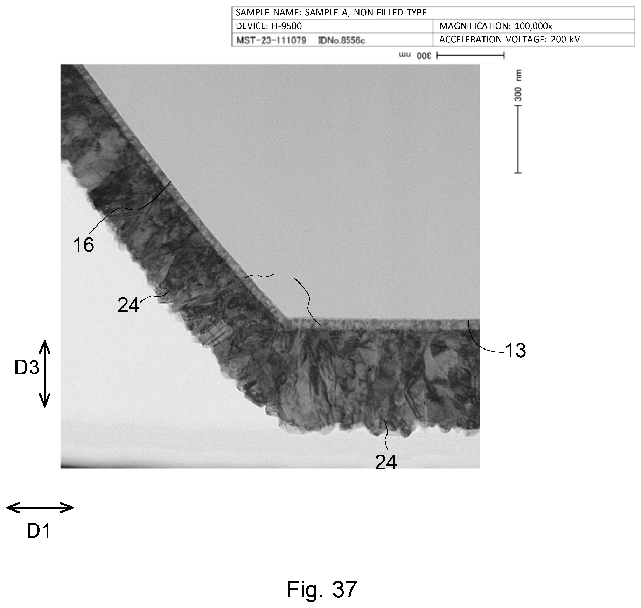

Fig. 37 is an image obtained as a result of observation of the adhesive layer 31 and the seed layer 24 at a position near the first surface 13. The observation was conducted under the following conditions.
· Observation device: H-9500 transmission electron microscope
· Magnification: 100000x
· Acceleration voltage: 200 kV

As illustrated in Fig. 37, at a position near the first surface 13, the adhesive layer 31 was present on the wall surface 16, and the seed layer 24 was present on the adhesive layer 31. The adhesive layer 31 extended continuously to at least a position at a distance Y1 (see Fig. 36) from the first surface 13 in the thickness direction D3. The distance Y1 was 15.4 µm.

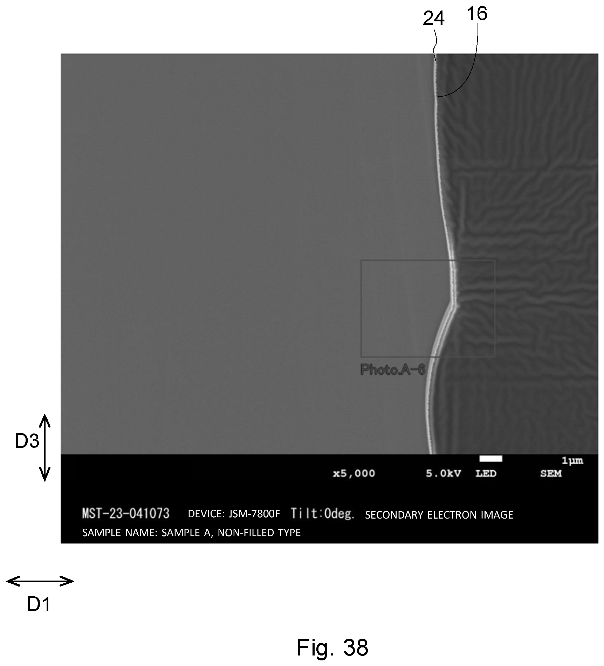

Fig. 38 is an image obtained as a result of observation of the through hole 15 and centered at a position at a distance Y2 (see Fig. 36) from the first surface 13 in the thickness direction D3. The distance Y2 was 26.2 µm. The observation was conducted under the following conditions.
· Observation device: JSM-7800F Schottky field-emission scanning electron microscope
· Magnification: 5000x
· Acceleration voltage: 5 kV

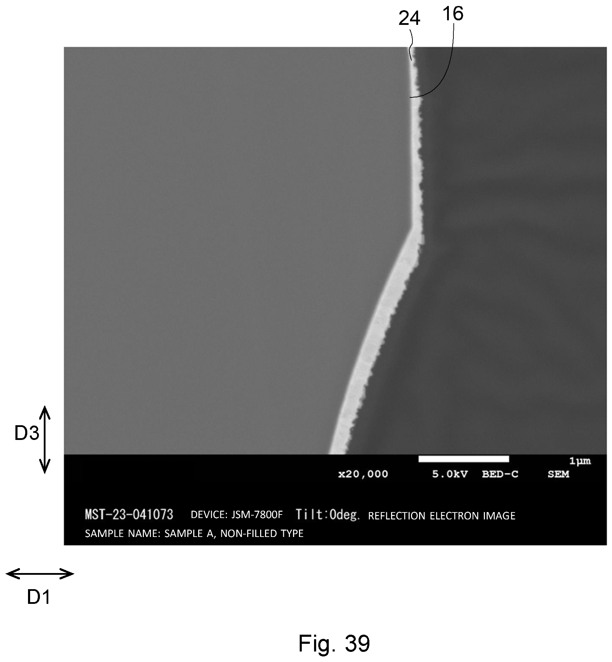

Fig. 39 is an image obtained as a result of observation of the through hole 15, illustrating a rectangular area denoted as "Photo A-6" in Fig. 38. The observation was conducted under the following conditions.
· Observation device: JSM-7800F Schottky field-emission scanning electron microscope
· Magnification: 20000x
· Acceleration voltage: 5 kV

As illustrated in Fig. 39, at a position away from the first surface 13 by 26.2 µm in the thickness direction D3, the seed layer 24 was present on the wall surface 16. No adhesive layer 31 was observed.

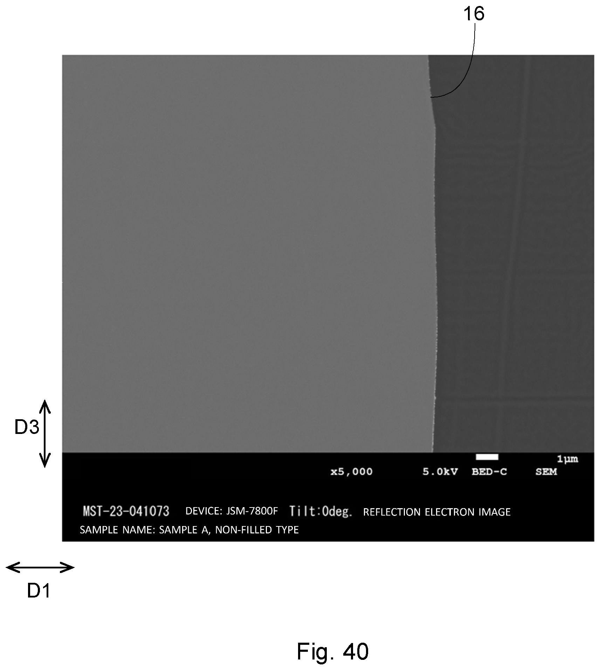

Fig. 40 is an image obtained as a result of observation of the through hole 15 and centered at a position at a distance Y3 (see Fig. 36) from the first surface 13 in the thickness direction D3. The distance Y3 was 155 µm. The observation was conducted under the following conditions.
· Observation device: JSM-7800F Schottky field-emission scanning electron microscope
· Magnification: 5000x
· Acceleration voltage: 5 kV

As illustrated in Fig. 40, at a position away from the first surface 13 by 155 µm in the thickness direction D3, neither the adhesive layer 31 nor the seed layer 24 was observed.

### (WORKING EXAMPLE B12)

As with the case of Working Example B1, after a through hole 15 was made in a substrate 12, an adhesive layer 31 and a through via 20 according to the above second embodiment were formed in the through hole 15. Subsequently, the through via 20 was observed through an electron microscope. The observation was conducted under the following conditions.
· Observation device: JSM-7800F Schottky field-emission scanning electron microscope
· Measurement area: 90 µm × 500 µm
· Measurement step : 0.6 µm
· Tilt of sample: 70°
· Acceleration voltage: 20 kV

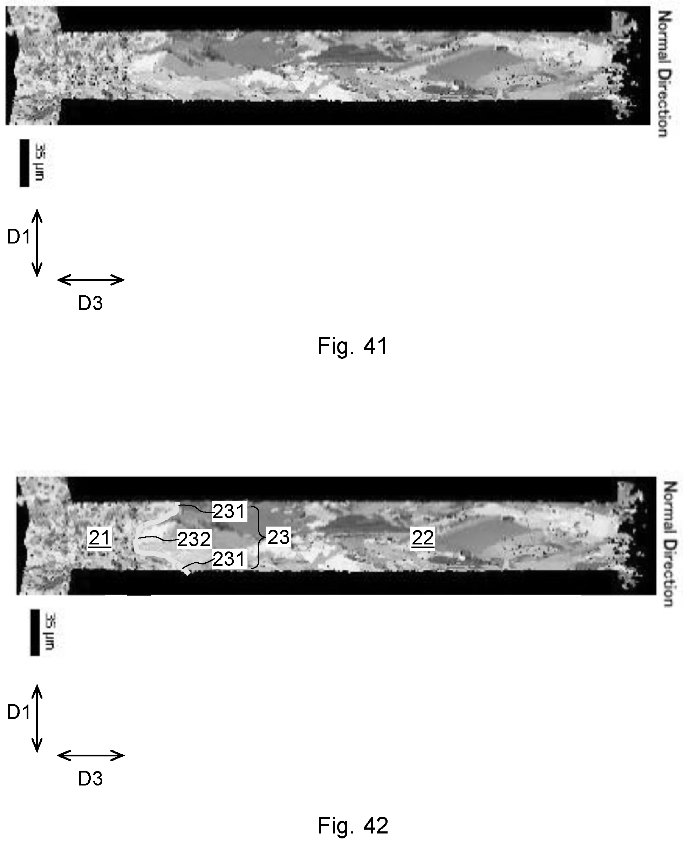

Fig. 41 is an image of an inverse pole figure orientation map generated from the result of observation. Fig. 42 is the image in Fig. 41 with the addition of lines and reference signs denoting the interface 23 between the first layer 21 and the second layer 22.

### Reference Signs List

10 through-via substrate
12 substrate
13 first surface
14 second surface
15 through hole
16 wall surface
20 through via
201 first end face
202 second end face
21 first layer
22 second layer
23 interface
231 interfacial end
232 dent
24 seed layer
241 third end
242 fourth end
31 adhesive layer
311 first end
312 second end
40 first wiring layer
41 first conductive layer
42 first insulating layer
50 second wiring layer
51 second conductive layer
52 second insulating layer
60 semiconductor device
61 terminal
62 bump
72 bump
80 motherboard
P1 first portion
P2 second portion
Pm1 first middle portion
Pm2 second middle portion

## Claims

1. A through-via substrate comprising:
a substrate including a first surface and a second surface located opposite the first surface, the substrate including a through hole including a wall surface extending from the first surface to the second surface;
a through via including a first end face located at the first surface and a second end face located at the second surface, the through via filling the through hole; and
an adhesive layer provided between the through via and the wall surface of the through hole,
wherein the through via includes a first layer including the first end face and a second layer including the second end face, the second layer being in contact with the first layer at an interface,
wherein the adhesive layer extends along the wall surface toward the second surface in such a manner as not to reach the second surface,
wherein the adhesive layer includes a second end where the adhesive layer extending toward the second surface terminates, and
wherein the interface is located between the first surface and the second end of the adhesive layer or between the second surface and the second end of the adhesive layer in a thickness direction of the substrate.

2. The through-via substrate according to claim 1, wherein the interface is located between the second surface and the second end of the adhesive layer in the thickness direction.

3. The through-via substrate according to claim 2, wherein a distance in the thickness direction between the first surface and the second end of the adhesive layer is 2 µm or more and 250 µm or less.

4. The through-via substrate according to claim 2, wherein a ratio of a distance in the thickness direction between the first surface and the interface with respect to a thickness of the substrate is 0.002 or more and 0.500 or less.

5. The through-via substrate according to claim 2, wherein a ratio of a distance in the thickness direction between the first surface and the interface with respect to a thickness of the substrate is 0.05 or more and 0.95 or less.

6. The through-via substrate according to claim 2,
wherein a distance in the thickness direction between the first surface and the second end of the adhesive layer is 5 µm or more, and
wherein a ratio of a distance in the thickness direction between the second surface and the interface with respect to a thickness of the substrate is greater than a ratio of a distance in the thickness direction between the first surface and the interface with respect to the thickness of the substrate.

7. The through-via substrate according to claim 1, wherein the interface is located between the first surface and the second end of the adhesive layer in the thickness direction.

8. The through-via substrate according to claim 7, wherein a distance in the thickness direction between the first surface and the interface is 5 µm or more and 250 µm or less.

9. The through-via substrate according to claim 7, wherein a ratio of a distance in the thickness direction between the first surface and the interface with respect to a thickness of the substrate is 0.010 or more and 0.500 or less.

10. The through-via substrate according to claim 7, wherein a ratio of a distance in the thickness direction between the first surface and the second end of the adhesive layer with respect to a thickness of the substrate is 0.05 or more and 0.95 or less.

11. The through-via substrate according to claim 7,
wherein a distance in the thickness direction between the first surface and the interface is 10 µm or more, and
wherein a ratio of a distance in the thickness direction between the second surface and the second end of the adhesive layer with respect to a thickness of the substrate is greater than a ratio of a distance in the thickness direction between the first surface and the second end of the adhesive layer with respect to the thickness of the substrate.

12. The through-via substrate according to any one of claims 1 to 11, wherein the adhesive layer contains titanium, a titanium compound, chromium, or a chromium compound.

13. The through-via substrate according to claim 12, wherein the through via contains copper.

14. The through-via substrate according to any one of claims 1 to 11, wherein the substrate contains glass and has a thickness of 300 µm or more and 1200 µm or less.

15. The through-via substrate according to any one of claims 1 to 11, further comprising:
at least one of a first wiring layer located at the first surface and a second wiring layer located at the second surface,
wherein the first wiring layer includes a first conductive layer and a first insulating layer, and
wherein the second wiring layer includes a second conductive layer and a second insulating layer.

16. The through-via substrate according to claim 15, further comprising: a semiconductor device including a terminal electrically connected to the through via.

17. The through-via substrate according to any one of claims 1 to 11,
wherein the through via includes a seed layer located on the adhesive layer, and
wherein a distance in the thickness direction between the interface and an end of the seed layer is 50 nm or less.

18. A method of manufacturing a through-via substrate, comprising:
a step of preparing a substrate including a first surface and a second surface located opposite the first surface, the substrate including a through hole including a wall surface extending from the first surface to the second surface;
a step of forming an adhesive layer on the wall surface; and
a through-via-forming step of forming a through via in the through hole,
wherein the adhesive layer extends along the wall surface toward the second surface in such a manner as not to reach the second surface,
wherein the adhesive layer includes a second end where the adhesive layer extending toward the second surface terminates,
wherein the through-via-forming step includes
a step of forming a seed layer including at least a portion located on the adhesive layer;
a first electroplating step of forming a first layer by electroplating such that the first layer covers the seed layer; and
a second electroplating step of forming a second layer by electroplating such that the second layer is in contact with the first layer at an interface, and
wherein the interface is located between the first surface and the second end of the adhesive layer or between the second surface and the second end of the adhesive layer in a thickness direction of the substrate.

19. The method of manufacturing a through-via substrate according to claim 18,
wherein the seed layer is present over the adhesive layer and the wall surface in such a manner as to cover the second end of the adhesive layer, and
wherein the interface is located between the second surface and the second end of the adhesive layer in the thickness direction.

20. The method of manufacturing a through-via substrate according to claim 18,
wherein the seed layer is present only on the adhesive layer, and
wherein the interface is located between the first surface and the second end of the adhesive layer in the thickness direction.

21. The method of manufacturing a through-via substrate according to any one of claims 18 to 20, wherein the adhesive layer is formed by chemical vapor deposition.

22. The method of manufacturing a through-via substrate according to claim 21, wherein the adhesive layer is formed by atomic layer deposition.

23. The method of manufacturing a through-via substrate according to any one of claims 18 to 20, wherein the seed layer is formed by physical film forming.
